# EUROPEAN PATENT APPLICATION

(11) **EP 4 006 077 A1**
(43) Date of publication of application: **01.06.2022**
(21) Application number: 20848386.7
(22) Date of filing: 16.07.2020
(51) Int. Cl.: C08G 61/12, H01L 51/42

(54) **METHOD FOR PRODUCING PI-CONJUGATED POLYMER**

(30) Priority: 30.07.2019 JP 2019139897
(71) Applicant: Sumitomo Chemical Company, Limited, Tokyo 103-6020 (JP)
(72) Inventor: INOKUCHI, Daisuke, Osaka-shi, Osaka 554-8558 (JP); ISHINO, Yuta, Osaka-shi, Osaka 554-8558 (JP); KASHIKI, Tomoya, Osaka-shi, Osaka 554-8558 (JP); MATSUSHITA, Shohei, Osaka-shi, Osaka 554-8558 (JP)
(74) Representative: J A Kemp LLP
(86) International application number: PCT/JP2020/027628
(87) International publication number: WO 2021/020141

(57) **Abstract**

Provided is a method for producing a π-conjugated polymer capable of suppressing an increase in dark current of an organic photoelectric conversion element even if the method includes a purification step including heating. A method for producing a π-conjugated polymer includes: step (I) of heating and dissolving a crude π-conjugated polymer in a solvent to obtain a polymer solution; and step (II) of precipitating a π-conjugated polymer from the polymer solution. In step (I), the content of peroxide in the solvent is 0.1% or less in terms of a relative area ratio measured by high-performance liquid chromatography, and the electron spin concentration of the π-conjugated polymer is 30 × 10¹⁶ Spin/g or less and/or 2.5 times or less the electron spin concentration of the crude π-conjugated polymer.

## Description

### TECHNICAL FIELD

The present invention relates to a method for producing a π-conjugated polymer that can be used as an organic photoelectric conversion material or the like, and a method for producing an organic photoelectric conversion element including an active layer containing the n-conjugated polymer.

### BACKGROUND ART

The organic photoelectric conversion element is attracting attention because the organic photoelectric conversion element is an extremely useful device, for example, from a viewpoint of energy saving and reduction of carbon dioxide emissions.

The organic photoelectric conversion element is an electronic element including at least a pair of electrodes including an anode and a cathode, and an active layer disposed between the pair of electrodes and containing an organic semiconductor material. In the organic photoelectric conversion element, one of the electrodes is made of a light-transmitting material, and light is incident on the active layer from the light-transmitting electrode side. At this time, energy (hv) of the light incident on the active layer generates charges (holes and electrons) in the active layer, the generated holes move toward the anode, and the electrons move toward the cathode. Then, the charges that have reached the anode and the cathode are taken out to the outside of the organic photoelectric conversion element.

The active layer of the organic photoelectric conversion element generally contains an organic photoelectric conversion material containing an n-type semiconductor material and a p-type semiconductor material, and a π-conjugated polymer is used as the organic photoelectric conversion material. It is known that some deterioration may occur in such a π-conjugated polymer, which affects the electrical characteristics of the organic photoelectric conversion element. For example, Patent Document 1 describes that an organic dye used in a photoelectric conversion device is photodecomposed by an active oxygen species generated during light irradiation.

### PRIOR ART DOCUMENTS

### PATENT DOCUMENTS

Patent Document 1: JP-A-2006-210102

### SUMMARY OF THE INVENTION

### PROBLEMS TO BE SOLVED BY THE INVENTION

However, a deterioration mechanism of an organic conversion material in a process for producing the organic photoelectric conversion material and an influence of the deterioration on the electrical characteristics of the organic photoelectric conversion element have not been clarified yet.

According to studies of the present inventor, it has been found that, when a π-conjugated polymer is produced through a purification process including heating, the electrical characteristics of an organic photoelectric conversion element using the π-conjugated polymer as a material may be deteriorated, particularly dark current may increase.

Therefore, an object of the present invention is to provide a method for producing a π-conjugated polymer capable of suppressing an increase in dark current of an organic photoelectric conversion element even if the method includes a purification step including heating, and a method for producing an organic photoelectric conversion element using the π-conjugated polymer.

### MEANS FOR SOLVING THE PROBLEMS

As a result of intensive studies to solve the above problems, the present inventor has found that, in a method for producing a π-conjugated polymer including a step of heating and dissolving a crude π-conjugated polymer in a solvent to obtain a polymer solution, peroxide contained in the solvent generates oxyl radicals by being heated, and the generated oxyl radicals extract electrons from the n-conjugated polymer to make the π-conjugated polymer radical-cationized, and the radical cationization increases an electron spin concentration to deteriorate the electrical characteristics of an organic photoelectric conversion element. Therefore, the present inventor has found that the above problems can be solved by adjusting the amount of peroxide in the solvent in the step to 0.1% or less and setting the electron spin concentration of the π-conjugated polymer within a specific range, and has completed the present invention. That is, the present invention includes the following preferred aspects.

[1] A method for producing a π-conjugated polymer, the method including: step (I) of heating and dissolving a crude π-conjugated polymer in a solvent to obtain a polymer solution; and step (II) of precipitating a π-conjugated polymer from the polymer solution, in which in step (I), the content of peroxide in the solvent is 0.1% or less in terms of a relative area ratio measured by high-performance liquid chromatography, and the electron spin concentration of the π-conjugated polymer is 30 × 10¹⁶ Spin/g or less and/or 2.5 times or less the electron spin concentration of the crude π-conjugated polymer.
[2] The method according to [1], in which the crude n-conjugated polymer is a D-A type crude π-conjugated polymer, and the π-conjugated polymer is a D-A type n-conjugated polymer.
[3] The method according to [1] or [2], in which in step (I), the solvent contains at least one selected from the group consisting of a benzyl hydrogen-containing aromatic solvent, a halogen atom-containing aromatic solvent, and an ether-based solvent.
[4] The method according to any one of [1] to [3], in which in step (I), the crude π-conjugated polymer is heated and dissolved at a temperature of 40°C or higher.
[5] A method for producing an organic photoelectric conversion element including a pair of electrodes including an anode and a cathode, and an active layer disposed between the pair of electrodes and containing a n-conjugated polymer produced by the method according to any one of [1] to [4].

### EFFECT OF THE INVENTION

The production method of the present invention can suppress an increase in dark current of an organic photoelectric conversion element even if the method includes a purification step including heating.

### MODE FOR CARRYING OUT THE INVENTION

### [Method for producing π-conjugated polymer]

A production method of the present invention includes step (I) of heating and dissolving a crude π-conjugated polymer in a solvent to obtain a polymer solution, and step (II) of precipitating a π-conjugated polymer from the polymer solution.

### <Step (I)>

Step (I) is a step of heating and dissolving a crude π-conjugated polymer in a solvent to obtain a polymer solution, in which the content of peroxide in the solvent (also referred to as the amount of peroxide) is 0.1% or less in terms of a relative area ratio measured by high-performance liquid chromatography.

By adjusting the amount of peroxide in the solvent used in step (I) to 0.1% or less, the amount of oxyl radicals generated from the peroxide by heating in steps (I) and (II), particularly in step (I) can be suppressed, and radical cationization of the π-conjugated polymer can be thereby effectively suppressed. Therefore, the electron spin concentration of the π-conjugated polymer can be 30 × 10¹⁶ Spin/g or less (also referred to as the electron spin concentration after the step), and/or 2.5 times or less the electron spin concentration of the crude π-conjugated polymer (also referred to as a change ratio of the electron spin concentration before and after the step). Therefore, the production method of the present invention can effectively suppress an increase in dark current and a decrease in external quantum efficiency (also referred to as EQE) of an organic photoelectric conversion element due to the purification step including heating.

### (Crude π-conjugated polymer)

The crude π-conjugated polymer refers to a high molecular weight compound containing a π-conjugated system. In the present specification, a π-conjugated polymer before being subjected to step (I) (before purification) is referred to as a crude π-conjugated polymer, but the structures of the crude π-conjugated polymer and the n-conjugated polymer are the same. In addition, in the present specification, "dark current is improved" means that dark current is reduced, and "external quantum efficiency is improved" means that external quantum efficiency is enhanced. Furthermore, in the present specification, the electrical characteristics may include dark current and external quantum efficiency, and "the electrical characteristics are enhanced" means, for example, that dark current and external quantum efficiency are improved.

Hereinafter, terms commonly used will be described in order to more specifically explain the crude π-conjugated polymer according to the present embodiment.

In the present specification, a "constituent unit" means a unit structure one or more of which are present in a crude π-conjugated polymer. The "constituent unit" is preferably included as a "repetition unit" (unit structure two or more of which are present in a crude π-conjugated polymer).

A "hydrogen atom" may be a light hydrogen atom or a deuterium atom.

A "halogen atom" includes a fluorine atom, a chlorine atom, a bromine atom, and an iodine atom.

"Optionally having a substituent" includes both a case where each of hydrogen atoms constituting the compound or group has no substituent and a case where some or all of one or more hydrogen atoms are replaced by substituents.

An "alkyl group" may be linear, branched, or cyclic unless otherwise specified. The number of carbon atoms of a linear alkyl group is usually 1 to 50, preferably 1 to 30, and more preferably 1 to 20 without including the number of carbon atoms of a substituent. The number of carbon atoms of a branched or cyclic alkyl group is usually 3 to 50, preferably 3 to 30, and more preferably 4 to 20 without including the number of carbon atoms of a substituent.

The alkyl group optionally has a substituent. Specific examples of the alkyl group include: an alkyl group such as a methyl group, an ethyl group, a n-propyl group, an isopropyl group, a n-butyl group, an isobutyl group, a tert-butyl group, a n-pentyl group, an isoamyl group, a 2-ethylbutyl group, a n-hexyl group, a cyclohexyl group, a n-heptyl group, a cyclohexylmethyl group, a cyclohexylethyl group, a n-octyl group, a 2-ethylhexyl group, a 3-n-propylheptyl group, an adamantyl group, a n-decyl group, a 3,7-dimethyl octyl group, a 2-ethyloctyl group, a 2-n-hexyl-decyl group, a n-dodecyl group, a tetradecyl group, a hexadecyl tomb, an octadecyl group, or an eicosyl group; and an alkyl group having a substituent, such as a trifluoromethyl group, a pentafluoroethyl group, a perfluorobutyl group, a perfluorohexyl group, a perfluorooctyl group, a 3-phenylpropyl group, a 3-(4-methylphenyl) propyl group, a 3-(3,5-di-n-hexylphenyl) propyl group, or a 6-ethyloxyhexyl group.

An "aryl group" means a remaining atomic group obtained by removing one hydrogen atom directly bonded to a carbon atom constituting a ring from an aromatic hydrocarbon optionally having a substituent.

The aryl group optionally has a substituent. Specific examples of the aryl group include a phenyl group, a 1-naphthyl group, a 2-naphthyl group, a 1-anthracenyl group, a 2-anthracenyl group, a 9-anthracenyl group, a 1-pyrenyl group, a 2-pyrenyl group, a 4-pyrenyl group, a 2-fluorenyl group, a 3-fluorenyl group, a 4-fluorenyl group, a 2-phenylphenyl group, a 3-phenylphenyl group, a 4-phenylphenyl group, and a group having a substituent such as an alkyl group, an alkoxy group, an aryl group, or a fluorine atom.

The "alkoxy group" may be linear, branched, or cyclic. The number of carbon atoms of a linear alkoxy group is usually 1 to 40, and preferably 1 to 10 without including the number of carbon atoms of a substituent. The number of carbon atoms of a branched or cyclic alkoxy group is usually 3 to 40, and preferably 4 to 10 without including the number of carbon atoms of a substituent.

The alkoxy group optionally has a substituent. Specific examples of the alkoxy group include a methoxy group, an ethoxy group, a n-propyloxy group, an isopropyloxy group, a n-butyloxy group, an isobutyloxy group, a tert-butyloxy group, a n-pentyloxy group, a n-hexyloxy group, a cyclohexyloxy group, a n-heptyloxy group, a n-octyloxy group, a 2-ethylhexyloxy group, a n-nonyloxy group, a n-decyloxy group, a 3,7-dimethyloctyloxy group, and a lauryloxy group.

The number of carbon atoms of an "aryloxy group" is usually 6 to 60, and preferably 6 to 48 without including the number of carbon atoms of a substituent.

The aryloxy group optionally has a substituent. Specific examples of the aryloxy group include a phenoxy group, a 1-naphthyloxy group, a 2-naphthyloxy group, a 1-anthracenyloxy group, a 9-anthracenyloxy group, a 1-pyrenyloxy group, and a group having a substituent such as an alkyl group, an alkoxy group, or a fluorine atom.

An "alkylthio group" may be linear, branched, or cyclic. The number of carbon atoms of a linear alkylthio group is usually 1 to 40, and preferably 1 to 10 without including the number of carbon atoms of a substituent. The number of carbon atoms of a branched or cyclic alkylthio group is usually 3 to 40, and preferably 4 to 10 without including the number of carbon atoms of a substituent.

The alkylthio group optionally has a substituent. Specific examples of the alkylthio group include a methylthio group, an ethylthio group, a propylthio group, an isopropylthio group, a butylthio group, an isobutylthio group, a tert-butylthio group, a pentylthio group, a hexylthio group, a cyclohexylthio group, a heptylthio group, an octylthio group, a 2-ethylhexylthio group, a nonylthio group, a decylthio group, a 3,7-dimethyloctylthio group, a laurylthio group, and a trifluoromethylthio group.

The number of carbon atoms of an "arylthio group" is usually 6 to 60, and preferably 6 to 48 without including the number of carbon atoms of a substituent.

The arylthio group optionally has a substituent. Examples of the arylthio group include a phenylthio group, a C1 to C12 alkyloxyphenylthio group (in which "C1 to C12" indicates that a group described immediately after "C1 to C12" has 1 to 12 carbon atoms, the same applies to the following), a C1-C12 alkylphenylthio group, a 1-naphthylthio group, a 2-naphthylthio group, and a pentafluorophenylthio group.

A "p-valent heterocyclic group" (p represents an integer of 1 or more) means a remaining atomic group obtained by removing p hydrogen atoms among hydrogen atoms directly bonded to a carbon atom or a hetero atom constituting a ring from a heterocyclic compound optionally having a substituent. Among the p-valent heterocyclic groups, a "p-valent aromatic heterocyclic group" is preferable. The "p-valent aromatic heterocyclic group" means a remaining atomic group obtained by removing p hydrogen atoms among hydrogen atoms directly bonded to a carbon atom or a hetero atom constituting a ring from an aromatic heterocyclic compound optionally having a substituent.

Here, examples of the substituent that the heterocyclic compound optionally has include a halogen atom, an alkyl group, an aryl group, an alkoxy group, an aryloxy group, an alkylthio group, an arylthio group, a monovalent heterocyclic group, a substituted amino group, an acyl group, an imine residue, an amide group, an acidimide group, a substituted oxycarbonyl group, an alkenyl group, an alkynyl group, a cyano group, and a nitro group.

The aromatic heterocyclic compound includes, in addition to a compound in which a heterocycle itself exhibits aromaticity, a compound in which an aromatic ring is fused to a heterocycle that does not exhibit aromaticity.

Among the aromatic heterocyclic compounds, specific examples of a compound in which a heterocycle itself exhibits aromaticity include oxadiazole, thiadiazole, thiazole, oxazole, thiophene, pyrrole, phosphole, furan, pyridine, pyrazine, pyrimidine, triazine, pyridazine, quinoline, isoquinolin, carbazole, and dibenzophosphole.

Among the aromatic heterocyclic compounds, specific examples of a compound in which an aromatic ring is fused to a heterocycle that does not exhibit aromaticity include phenoxazine, phenothiazine, dibenzoborole, dibenzosilole, and benzopyran.

The number of carbon atoms of a monovalent heterocyclic group is usually 2 to 60, and preferably 4 to 20 without including the number of carbon atoms of a substituent.

The monovalent heterocyclic group optionally has a substituent, and specific examples of the monovalent heterocyclic group include a thienyl group, a pyrrolyl group, a furyl group, a pyridyl group, a piperidyl group, a quinolyl group, an isoquinolyl group, a pyrimidinyl group, a triazinyl group, and a group in which each of these groups has a substituent such as an alkyl group or an alkoxy group.

A "substituted amino group" means an amino group having a substituent. Examples of the substituent that the substituted amino group can have include an alkyl group, an aryl group, and a monovalent heterocyclic group. As the substituent, an alkyl group, an aryl group, or a monovalent heterocyclic group is preferable. The number of carbon atoms of the substituted amino group is usually 2 to 30.

Examples of the substituted amino group include: a dialkylamino group such as a dimethylamino group or a diethylamino group; and a diarylamino group such as a diphenylamino group, a bis(4-methylphenyl) amino group, a bis(4-tert-butylphenyl) amino group, or a bis(3,5-di-tert-butylphenyl) amino group.

The number of carbon atoms of an "acyl group" is usually 2 to 20, and preferably 2 to 18. Specific examples of the acyl group include an acetyl group, a propionyl group, a butyryl group, an isobutyryl group, a pivaloyl group, a benzoyl group, a trifluoroacetyl group, and a pentafluorobenzoyl group.

An "imine residue" means a remaining atomic group obtained by removing one hydrogen atom directly bonded to a carbon atom or a nitrogen atom constituting a carbon atom-nitrogen atom double bond from an imine compound. The "imine compound" means an organic compound having a carbon atom-nitrogen atom double bond in a molecule thereof. Examples of the imine compound include a compound in which a hydrogen atom bonded to a nitrogen atom constituting a carbon atom-nitrogen atom double bond in aldimine, ketimine, or aldimine is replaced by an alkyl group or the like.

The number of carbon atoms of the imine residue is usually 2 to 20, and preferably 2 to 18. Examples of the imine residue include groups represented by the following structural formulas.

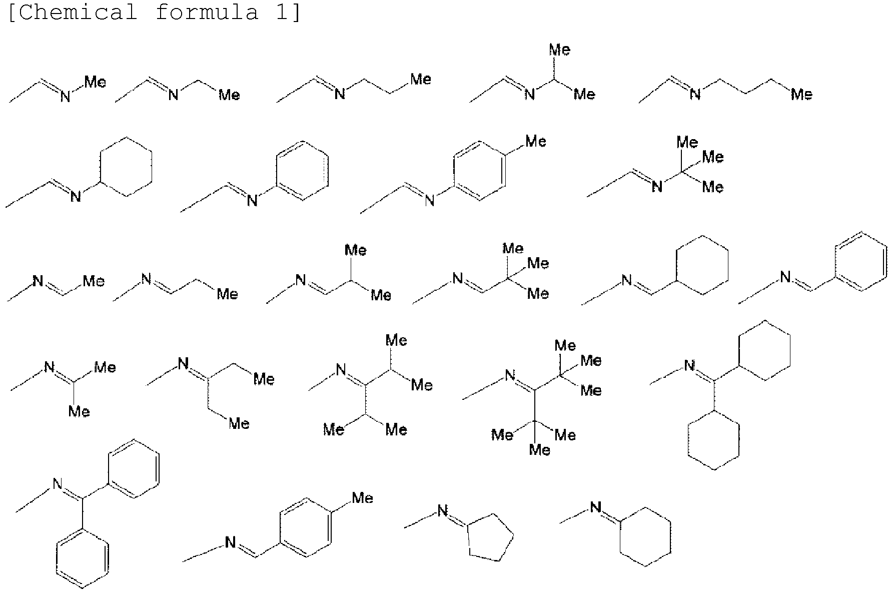

An "amide group" means a remaining atomic group obtained by removing one hydrogen atom bonded to a nitrogen atom from an amide. The number of carbon atoms of the amide group is usually 1 to 20, and preferably 1 to 18. Specific examples of the amide group include a formamide group, an acetamide group, a propioamide group, a butyroamide group, a benzamide group, a trifluoroacetamide group, a pentafluorobenzamide group, a diformamide group, a diacetamide group, a dipropioamide group, a dibutyroamide group, a dibenzamide group, a ditrifluoroacetamide group, and a dipentafluorobenzamide group.

An "acidimide group" means a remaining atomic group obtained by removing one hydrogen atom bonded to a nitrogen atom from an acidimide. The number of carbon atoms of the acidimide group is usually 4 to 20. Specific examples of the acidimide group include groups represented by the following structural formulas.

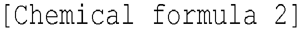

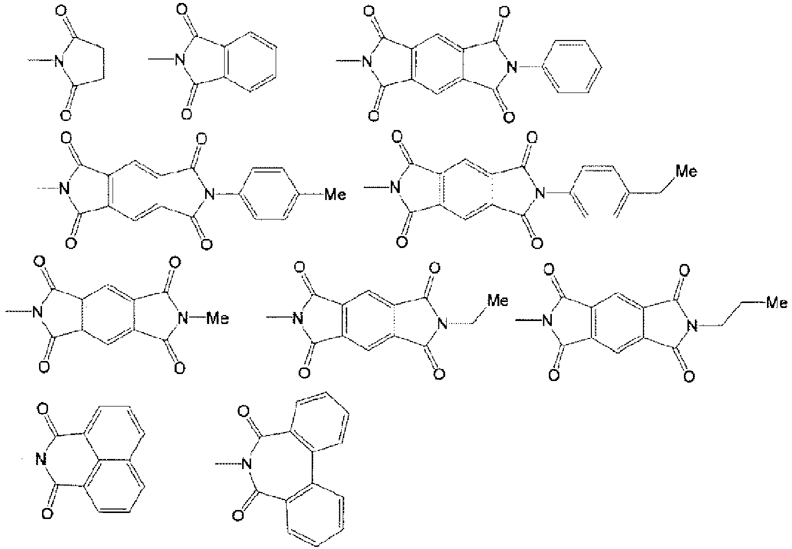

The "substituted oxycarbonyl group" means a group represented by R'-O-(C=O)-. Here, R' represents an alkyl group, an aryl group, an arylalkyl group, or a monovalent heterocyclic group.

The number of carbon atoms of the substituted oxycarbonyl group is usually 2 to 60, and preferably 2 to 48.

Specific examples of the substituted oxycarbonyl group include a methoxycarbonyl group, an ethoxycarbonyl group, a propoxycarbonyl group, an isopropoxycarbonyl group, a butoxycarbonyl group, an isobutoxycarbonyl group, a tert-butoxycarbonyl group, a pentyloxycarbonyl group, a hexyloxycarbonyl group, a cyclohexyloxycarbonyl group, a heptyloxycarbonyl group, an octyloxycarbonyl group, a 2-ethylhexyloxycarbonyl group, a nonyloxycarbonyl group, a decyloxycarbonyl group, a 3,7-dimethyloctyloxycarbonyl group, a dodecyloxycarbonyl group, a trifluoromethoxycarbonyl group, a pentafluoroethoxycarbonyl group, a perfluorobutoxycarbonyl group, a perfluorohexyloxycarbonyl group, a perfluorooctyloxycarbonyl group, a phenoxycarbonyl group, a naphthoxycarbonyl group, and a pyridyloxycarbonyl group.

The "alkenyl group" may be linear, branched, or cyclic. The number of carbon atoms of a linear alkenyl group is usually 2 to 30, and preferably 3 to 20 without including the number of carbon atoms of a substituent. The number of carbon atoms of a branched or cyclic alkenyl group is usually 3 to 30, and preferably 4 to 20 without including the number of carbon atoms of a substituent.

The alkenyl group optionally has a substituent. Specific examples of the alkenyl group include a vinyl group, a 1-propenyl group, a 2-propenyl group, a 2-butenyl group, a 3-butenyl group, a 3-pentenyl group, a 4-pentenyl group, a 1-hexenyl group, a 5-hexenyl group, a 7-octenyl group, and a group in which each of these groups has a substituent such as an alkyl group or an alkoxy group.

The "alkynyl group" may be linear, branched, or cyclic. The number of carbon atoms of a linear alkenyl group is usually 2 to 20, and preferably 3 to 20 without including the number of carbon atoms of a substituent. The number of carbon atoms of a branched or cyclic alkenyl group is usually 4 to 30, and preferably 4 to 20 without including the number of carbon atoms of a substituent.

The alkynyl group optionally has a substituent. Specific examples of the alkynyl group include an ethynyl group, a 1-propynyl group, a 2-propynyl group, a 2-butynyl group, a 3-butynyl group, a 3-pentynyl group, a 4-pentynyl group, a 1-hexynyl group, a 5-hexynyl group, and a group in which each of these groups has a substituent such as an alkyl group or an alkoxy group.

Examples of the crude π-conjugated polymer include polyvinylcarbazole and a derivative thereof, polysilane and a derivative thereof, a polysiloxane derivative having an aromatic amine structure in a side chain thereof or a main chain thereof, polyaniline and a derivative thereof, polythiophene and a derivative thereof, polypyrrole and a derivative thereof, polyphenylene vinylene and a derivative thereof, polythienylene vinylene and a derivative thereof, and polyfluorene and a derivative thereof.

The crude π-conjugated polymer may be any kind of copolymer, and may be, for example, a block copolymer, a random copolymer, an alternating copolymer, or a graft copolymer.

The crude π-conjugated polymer is preferably a polymer containing a constituent unit represented by the following formula (I) and/or a constituent unit represented by the following formula (II) from a viewpoint of easily improving dark current and external quantum efficiency of an organic photoelectric conversion element.

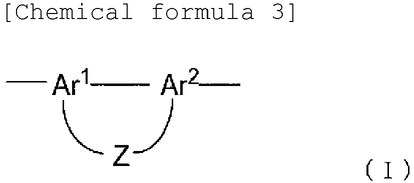

In formula (I), Ar¹ and Ar² each represent a trivalent aromatic heterocyclic group, and Z represents a group represented by any one of the following formulas (Z-1) to (Z-7).

[Chemical formula 4]

**-Ar³-** (II)

In formula (II), Ar³ represents a divalent aromatic heterocyclic group.

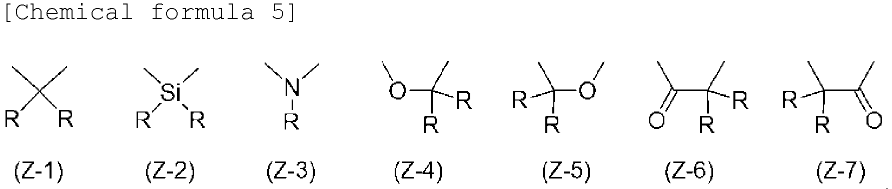

In formulas (Z-1) to (Z-7), R represents a hydrogen atom, a halogen atom, an alkyl group, an aryl group, an alkoxy group, an aryloxy group, an alkylthio group, an arylthio group, a monovalent heterocyclic group, a substituted amino group, an acyl group, an imine residue, an amide group, an acidimide group, a substituted oxycarbonyl group, an alkenyl group, an alkynyl group, a cyano group, or a nitro group. When two Rs are present in each of formulas (Z-1) to (Z-7), the two Rs may be the same as or different from each other.

The constituent unit represented by formula (I) is preferably a constituent unit represented by the following formula (I-1).

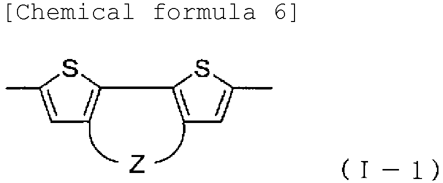

In formula (I-1), Z has a similar meaning to Z described above.

Examples of the constituent unit represented by formula (I-1) include constituent units represented by the following formulas (501) to (505).

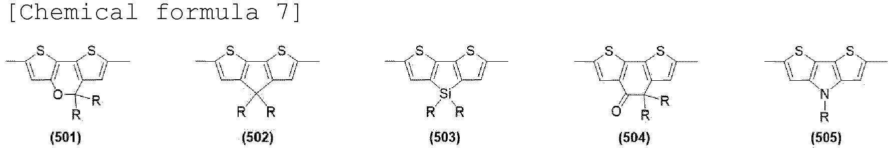

In the above formulas (501) to (505), R has a similar meaning to R described above. When there are two Rs, the two Rs may be the same as or different from each other.

The number of carbon atoms contained in the divalent aromatic heterocyclic group represented by Ar³ is usually 2 to 60, preferably 4 to 60, and more preferably 4 to 20. The divalent aromatic heterocyclic group represented by Ar³ optionally has a substituent. Examples of the substituent that the divalent aromatic heterocyclic group represented by Ar³ optionally has include a halogen atom, an alkyl group, an aryl group, an alkoxy group, an aryloxy group, an alkylthio group, an arylthio group, a monovalent heterocyclic group, a substituted amino group, an acyl group, an imine residue, an amide group, an acidimide group, a substituted oxycarbonyl group, an alkenyl group, an alkynyl group, a cyano group, and a nitro group.

Examples of the divalent aromatic heterocyclic group represented by Ar³ include groups represented by the following formulas (101) to (185).

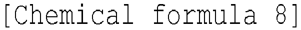

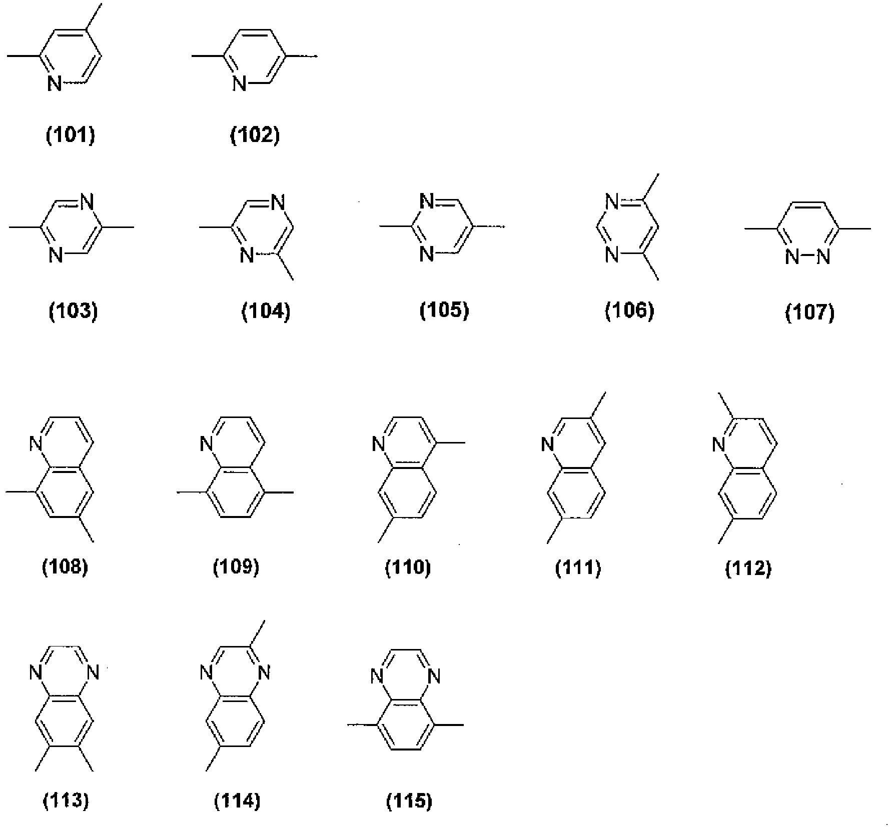

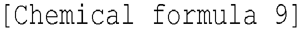

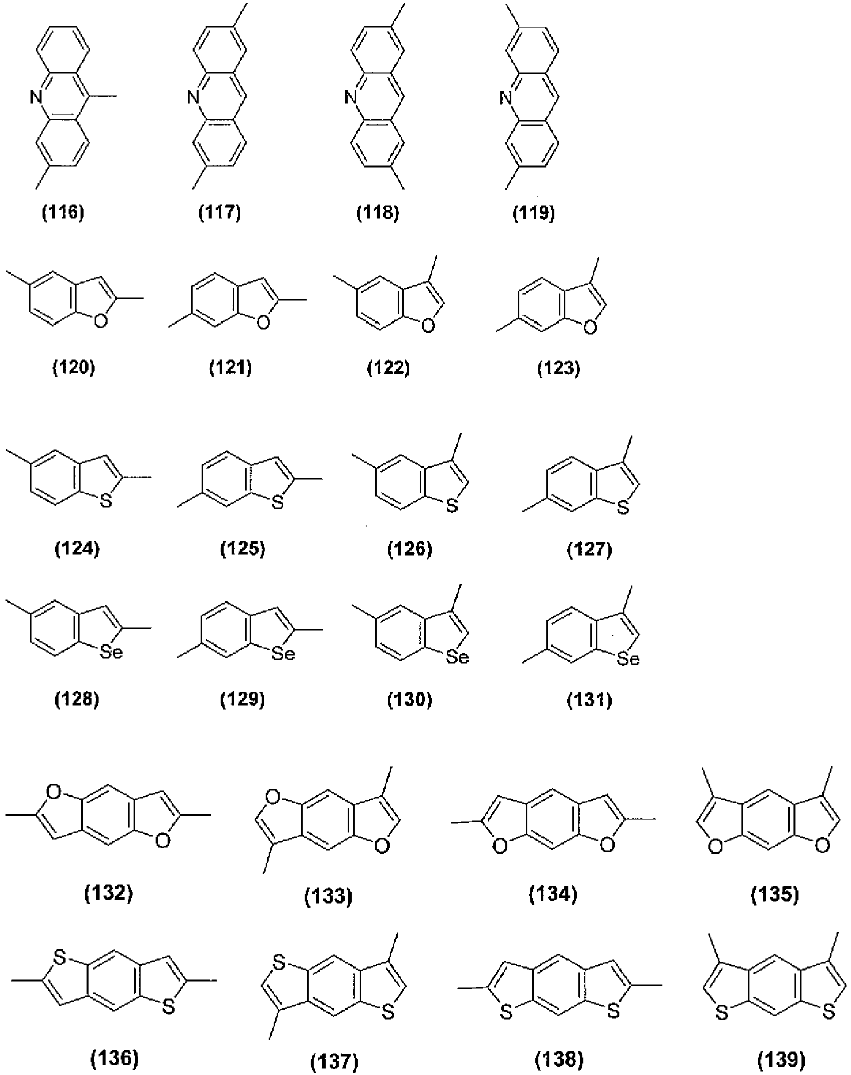

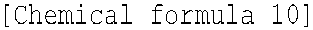

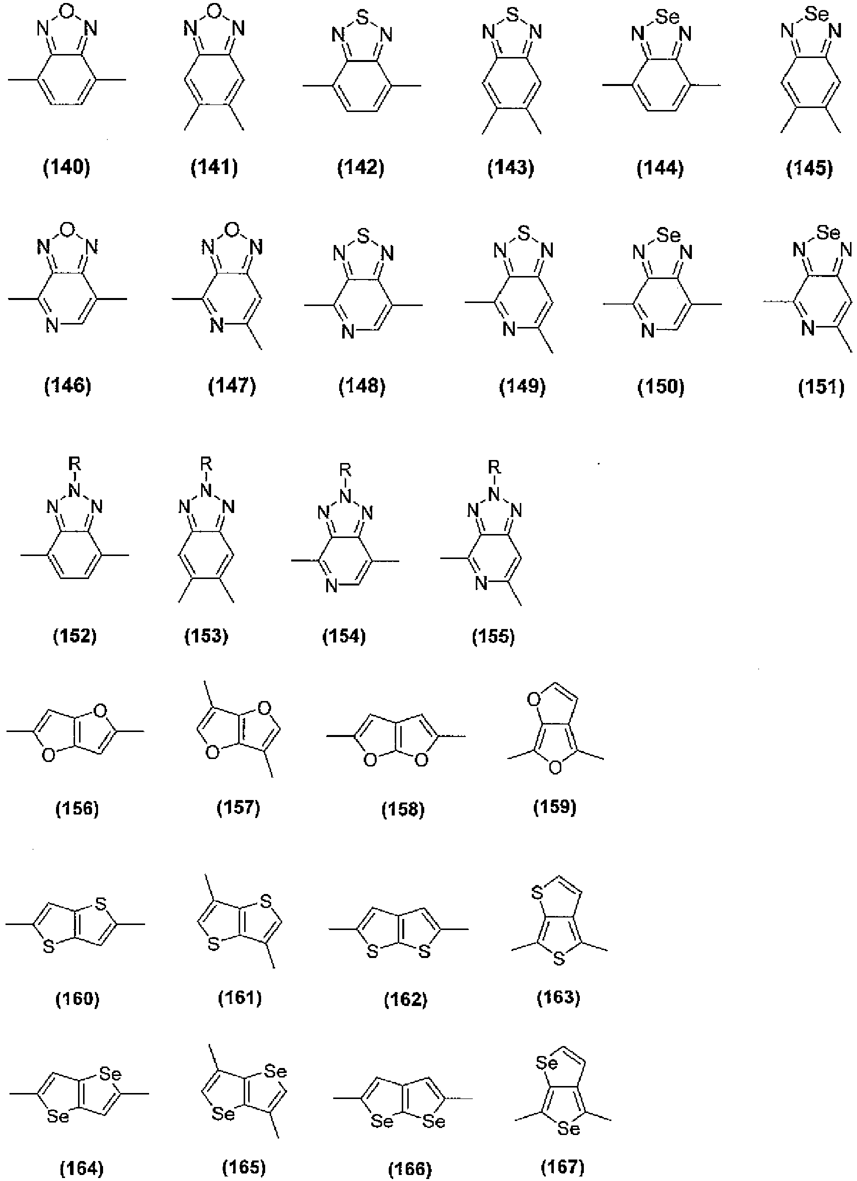

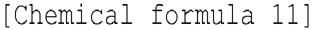

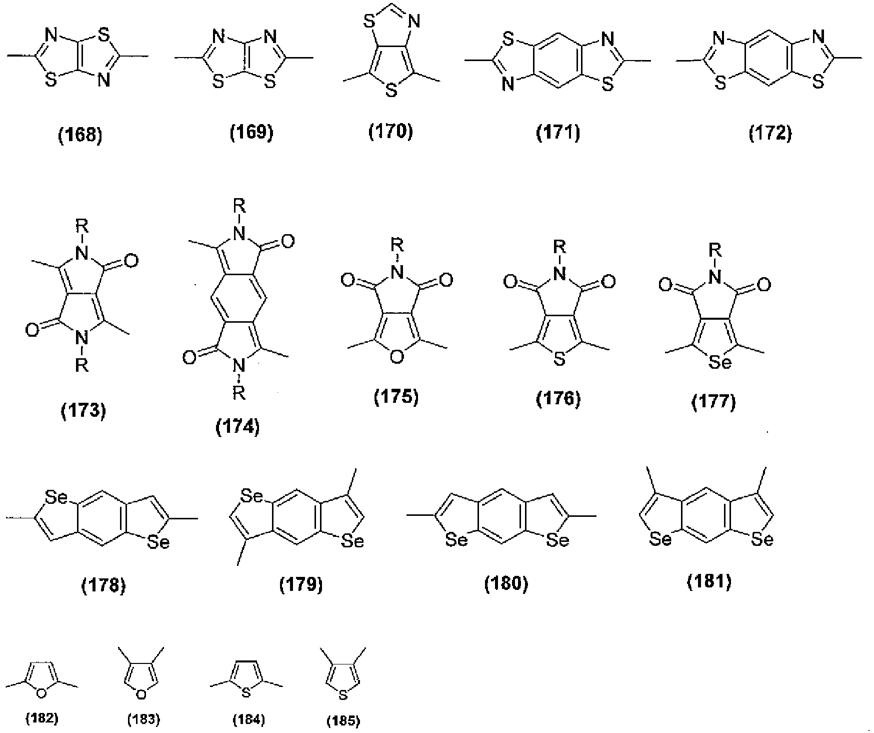

In formulas (101) to (185), R has the same meaning as R described above. When there is a plurality of Rs, the plurality of Rs may be the same as or different from each other.

As the constituent unit represented by the formula (II), constituent units represented by the following formulas (II-1) to (II-6) are preferable.

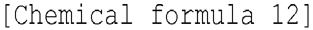

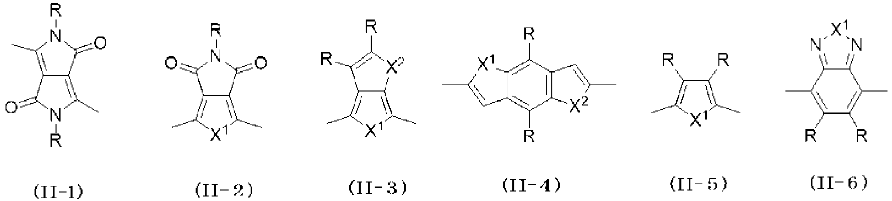

In formulas (II-1) to (II-6), X¹ and X² each independently represent an oxygen atom or a sulfur atom, and R has the same meaning as R described above. When there is a plurality of Rs, the plurality of Rs may be the same as or different from each other.

Both X¹ and X² in formulas (II-1) to (II-6) are preferably sulfur atoms because a raw material compound is easily available.

The crude π-conjugated polymer may contain two or more types of constituent units of formula (I), or may contain two or more types of constituent units of formula (II).

The crude π-conjugated polymer may contain a constituent unit represented by the following formula (III) in order to enhance solubility thereof in a solvent.

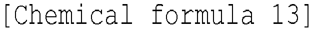

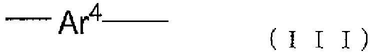

In formula (III), Ar⁴ represents an arylene group.

The arylene group represented by Ar⁴ means a remaining atomic group obtained by removing two hydrogen atoms from an aromatic hydrocarbon optionally having a substituent. The aromatic hydrocarbon also includes a compound in which two or more selected from the group consisting of a compound having a fused ring, an independent benzene ring, and an independent fused ring are bonded directly or via a divalent group such as vinylene.

Examples of the substituent that the aromatic hydrocarbon optionally has include similar substituents to those exemplified above as the substituent that the heterocyclic compound optionally has.

The number of carbon atoms in a portion of the arylene group excluding a substituent is usually 6 to 60, and preferably 6 to 20. The number of carbon atoms of the arylene group including a substituent is usually about 6 to 100.

Examples of the arylene group include a phenylene group (for example, the following formulas 1 to 3), a naphthalene-diyl group (for example, the following formulas 4 to 13), an anthracene-diyl group (for example, the following formulas 14 to 19), a biphenyl-diyl group (for example, the following formulas 20 to 25), a terphenyl-diyl group (for example, the following formulas 26 to 28), a fused ring compound group (for example, the following formulas 29 to 35), a fluorene-diyl group (for example, the following formulas 36 to 38), and a benzofluorene-diyl group (for example, the following formulas 39 to 46).

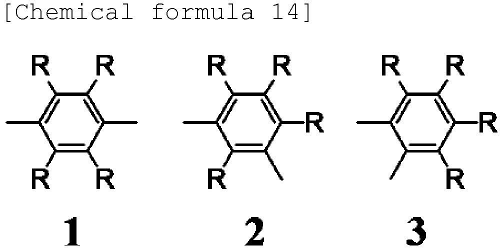

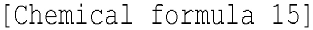

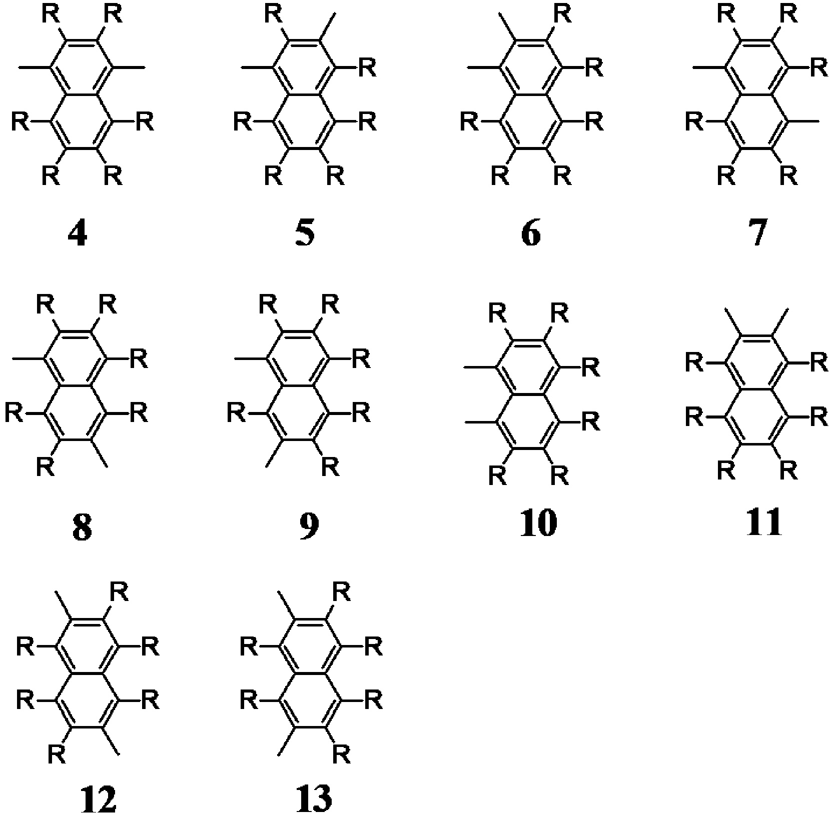

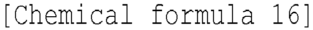

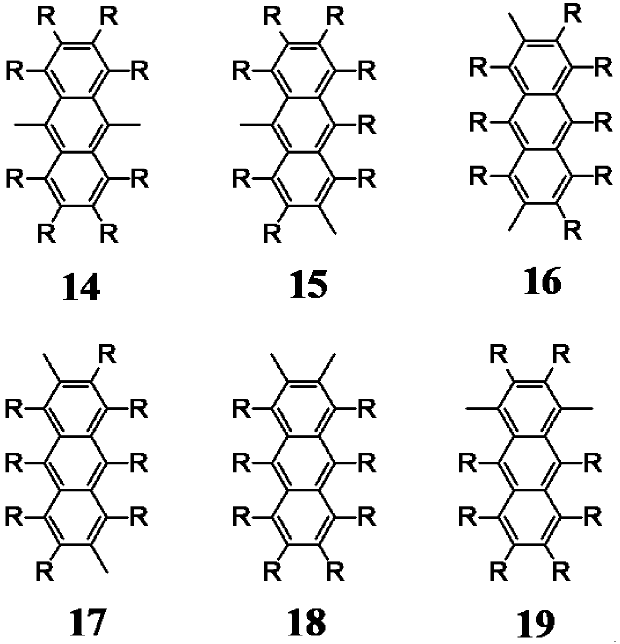

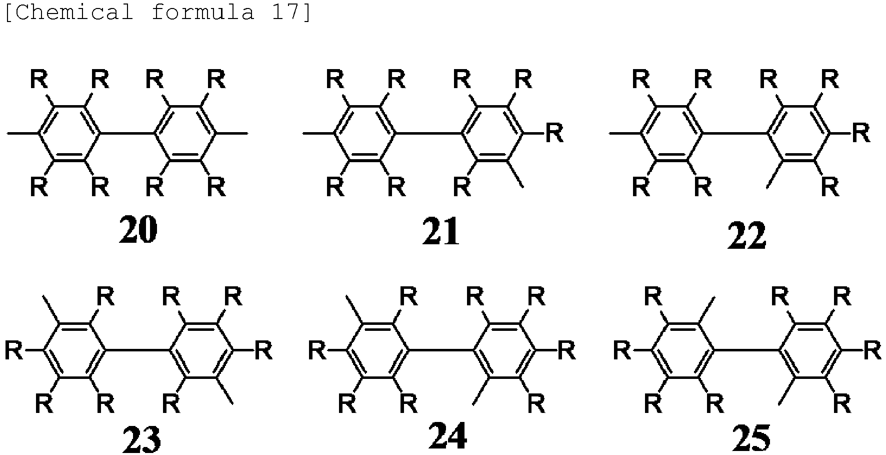

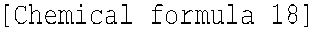

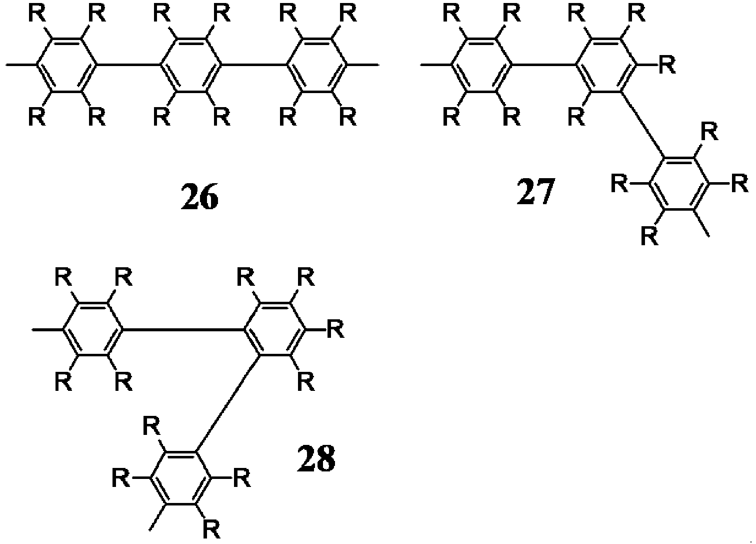

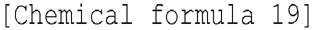

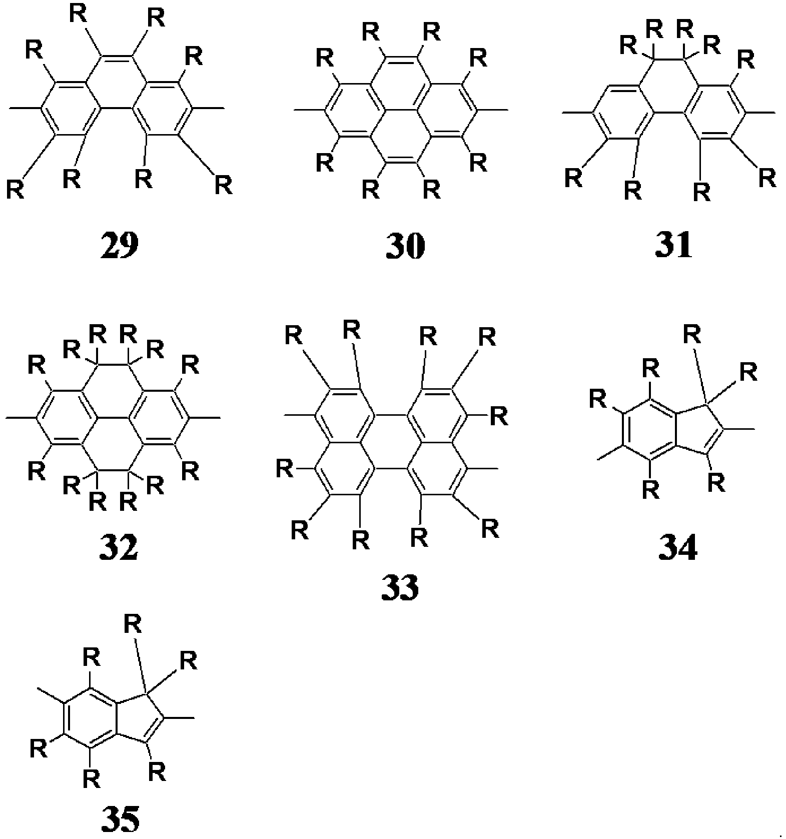

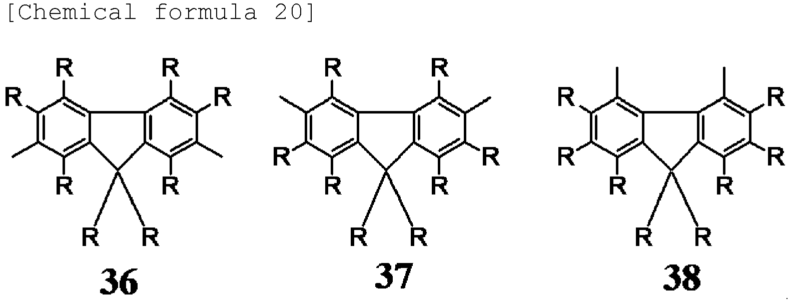

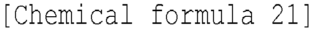

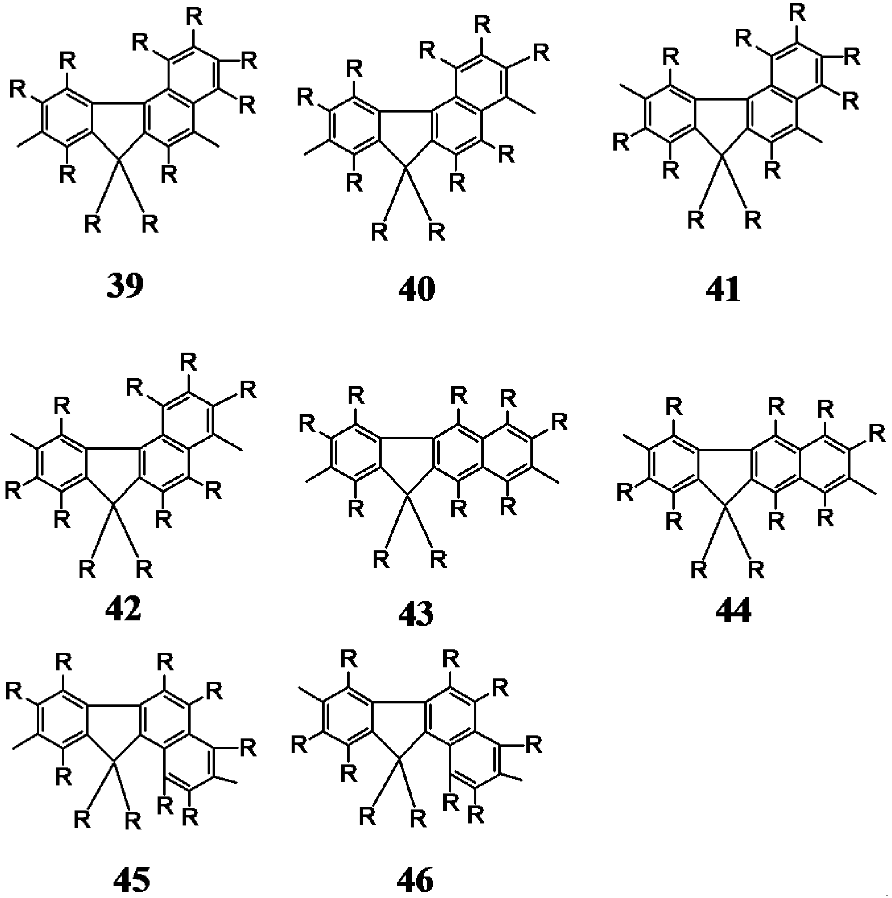

In one embodiment of the present invention, the crude π-conjugated polymer is preferably a D-A type (donor-acceptor type) polymer. The D-A type crude π-conjugated polymer means a polymer containing both an electron-donating site and an electron-accepting site in a molecule thereof.

In step (I), the D-A type crude π-conjugated polymer often has low solubility in an organic solvent such as an aromatic solvent, and it is highly needed to heat and dissolve the D-A type crude π-conjugated polymer at a predetermined temperature or higher in step (I). Therefore, peroxide in the solvent is decomposed to easily generate oxyl radicals. Therefore, a change ratio of an electron spin concentration before and after the step tends to be large. As a result, an increase in dark current and a decrease in external quantum efficiency of an organic photoelectric conversion element easily occur. However, if the production method of the present invention is used, the electron spin concentration and the change ratio thereof are controlled. Therefore, even when the D-A type crude n-conjugated polymer is used as a raw material, an increase in dark current and a decrease in external quantum efficiency of an organic photoelectric conversion element can be effectively suppressed. Note that in this case, of course, an obtained π-conjugated polymer is a D-A type n-conjugated polymer.

When the crude π-conjugated polymer contains a constituent unit represented by formula (I) and/or a constituent unit represented by formula (II), the total amount of the constituent unit represented by formula (I) and the constituent unit represented by formula (II) is usually 20 to 100 mol%, in which the amount of all the constituent units contained in the crude π-conjugated polymer is 100 mol%. The total amount of the constituent unit represented by formula (I) and the constituent unit represented by formula (II) is preferably 40 to 100 mol%, and more preferably 50 to 100 mol% from a viewpoint of enhancing charge transportability of the π-conjugated polymer.

In one embodiment of the present invention, the crude π-conjugated polymer preferably has a thiophene ring from a viewpoint of easily improving dark current and external quantum efficiency of an organic photoelectric conversion element. For example, when the π-conjugated polymer is a polymer containing a constituent unit represented by formula (I) and/or a constituent unit represented by formula (II), preferably, Ar¹ and/or Ar² in formula (I) is a constituent unit containing a thiophene ring, and/or Ar³ in formula (II) is a constituent unit containing a thiophene ring.

Specific examples of the crude π-conjugated polymer include polymers represented by the following formulas. Note that a preferable ratio (mol%) of each structural site is described below, but the ratio is not limited to the ratio.

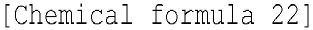

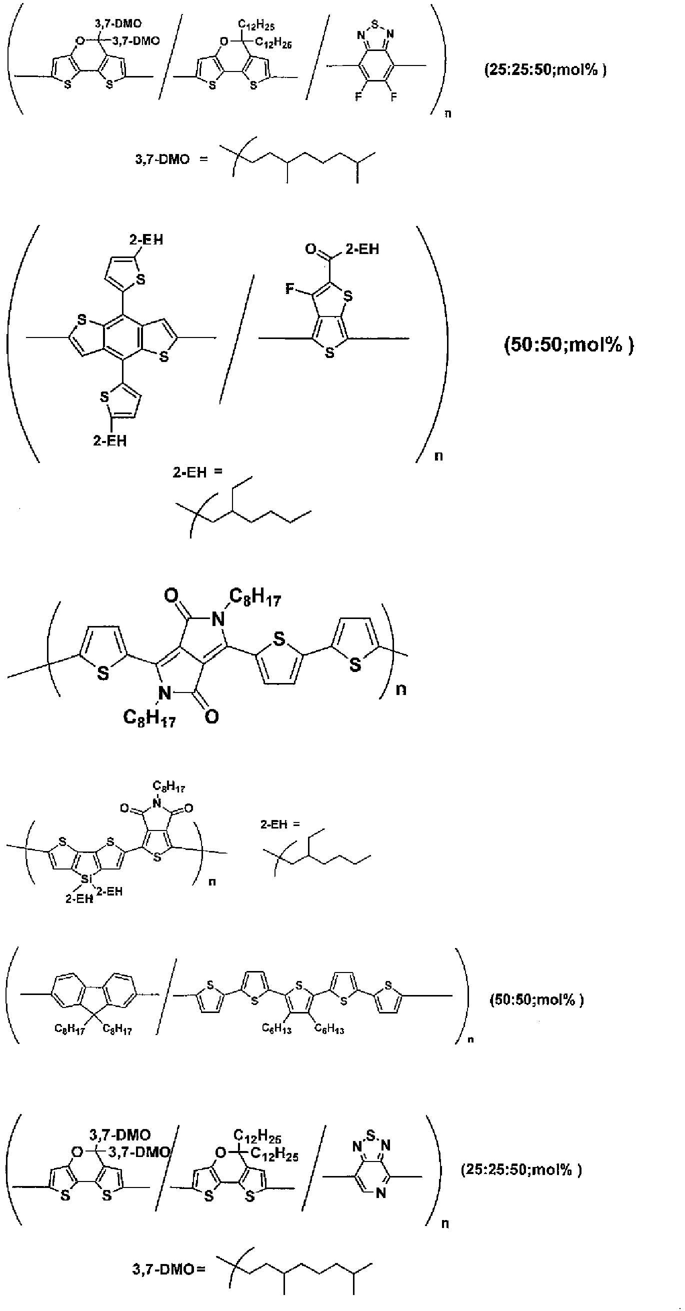

The weight average molecular weight of the crude n-conjugated polymer in terms of polystyrene is preferably 40,000 to 200,000, and more preferably 40,000 to 150,000 particularly from a viewpoint of reducing dark current, and still more preferably 45,000 to 150,000 particularly from a viewpoint of enhancing solubility in a solvent. Note that the weight average molecular weight (Mw) can be measured by gel permeation chromatography (GPC), for example, by a method described in Examples.

### (Solvent)

The solvent for dissolving the crude π-conjugated polymer is not particularly limited as long as the solvent can dissolve the polymer, and examples of the solvent include an aromatic solvent, an ether-based solvent, an alcohol-based solvent, an ester-based solvent, a ketone-based solvent, an aliphatic hydrocarbon-based solvent, an alicyclic hydrocarbon-based solvent, a nitrile-based solvent, an amide-based solvent, a carbonate-based solvent, a sulfur-containing solvent, and a chlorine-containing solvent. These solvents can be used singly or in combination of two or more types thereof. Among these solvents, it is preferable to use a solvent containing at least one selected from the group consisting of a benzyl hydrogen-containing aromatic solvent, a halogen atom-containing aromatic solvent, and an ether-based solvent from a viewpoint of solubility, and it is more preferable to use a solvent containing at least one selected from the group consisting of a benzyl hydrogen-containing aromatic solvent and an ether-based solvent from a viewpoint of easiness in effectively suppressing deterioration of the solubility and the electrical characteristics of an organic photoelectric conversion element. The benzyl hydrogen-containing aromatic solvent and the ether-based solvent are easily oxidized by oxygen or the like in the air and easily generate peroxide. Therefore, the amount of peroxide tends to be large. Therefore, a large amount of oxyl radicals tend to be generated by heating and dissolving, and as a result, the electrical characteristics of an organic photoelectric conversion element tend to be significantly deteriorated. In the production method of the present invention, even when such a solvent is used, since the amount of peroxide in the solvent is adjusted, deterioration of the electrical characteristics of an organic photoelectric conversion element can be effectively suppressed. Therefore, the production method of the present invention is more effective when at least one selected from the group consisting of a benzyl hydrogen-containing aromatic solvent and an ether-based solvent is used as a solvent for dissolving the π-conjugated polymer.

The aromatic solvent refers to a solvent containing an aromatic ring, and examples of the aromatic ring include a benzene ring and a naphthalene ring. Examples of the benzyl hydrogen-containing aromatic solvent include toluene, xylene (for example, o-xylene, m-xylene, or p-xylene), trimethylbenzene (for example, mesitylene, 1,2,4-trimethylbenzene (pseudocumene)), dimethyl-ethylbenzene (for example, 1,3-dimethyl-4-ethylbenzene), butylbenzene (for example, n-butylbenzene, sec-butylbenzene, or tert-butylbenzene), methylnaphthalene (for example, 1-methylnaphthalene or 2-methylnaphthalene), ethylnaphthalene (for example, 2-ethylnaphthalene), tetralin, indane, dichloro-methylbenzene (for example, 1,2-dichloro-4-methylbenzene), and cresol. In the present specification, the benzyl hydrogen refers to a hydrogen atom bonded to a carbon atom directly bonded to an aromatic ring (benzene ring, naphthalene ring, or the like). In addition, in the present specification, when the aromatic solvent contains both a benzyl hydrogen and a halogen atom, the aromatic solvent is classified into a benzyl hydrogen-containing aromatic solvent.

The halogen atom-containing aromatic solvent refers to an aromatic solvent containing a halogen atom, and examples thereof include chloronaphthalene (for example, 2-chloronaphthalene), chlorobenzene, dichlorobenzene (o-dichlorobenzene), and chloro-fluorobenzene (for example, 1-chloro-2-fluorobenzene) .

Among the aromatic solvents, an aromatic solvent containing a compound represented by formula (A) is particularly preferable from a viewpoint of having high solubility of a π-conjugated polymer and easily enhancing the electrical characteristics of an organic photoelectric conversion element.

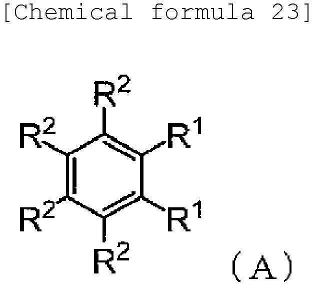

In formula (A), R¹ represents a halogen atom or an alkyl group. The two R¹s may be the same as or different from each other. The two R¹s may be bonded to each other to form a ring.

In formula (A), R² represents a hydrogen atom, a halogen atom, or an alkyl group. The plurality of R²s may be the same as or different from each other. Among the two R¹s and the four R²s, any one R¹ or R² is preferably an alkyl group, any one R¹ is more preferably an alkyl group, and both of the two R¹s are still more preferably alkyl groups from a viewpoint of easiness in effectively exhibiting the effects of the present invention.

Examples of the halogen atom in R¹ and R² include the halogen atoms described in the section of "(Crude n-conjugated polymer)", and examples of the alkyl group in R¹ and R² include the alkyl groups described in the section of "(Crude π-conjugated polymer)".

As the compound represented by formula (A), compounds represented by the following formula are preferable from a viewpoint of having high solubility of a crude π-conjugated polymer and easily enhancing the electrical characteristics of an organic photoelectric conversion element.

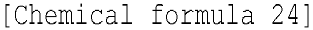

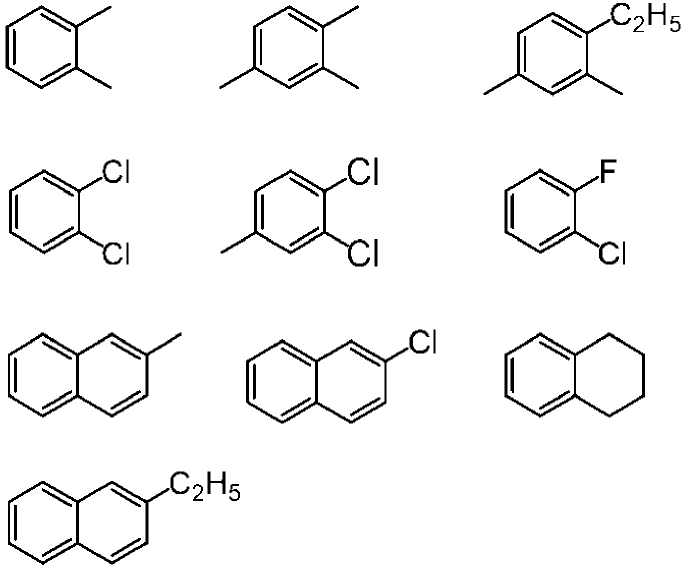

Examples of the ether-based solvent include anisole, cyclopentyl methyl ether, tert-butyl methyl ether, diethyl ether, diisopropyl ether, ethylene glycol dimethyl ether, diethylene glycol dimethyl ether, tetrahydrofuran, 2-methyltetrahydrofuran, and 1,4-dioxane.

The amount of peroxide in the solvent used in step (I) is 0.1% or less, preferably 0.08% or less, more preferably 0.05% or less, and still more preferably 0.03% or less in terms of a relative area ratio measured by high-performance liquid chromatography. When the amount of peroxide is the above upper limit or less, the change ratio of the electron spin concentration before and after the step and the electron spin concentration after the step are easily reduced, and therefore an increase in dark current and a decrease in EQE in an organic photoelectric conversion element are easily suppressed. In addition, a lower limit of the amount of peroxide in the solvent is usually 0%. Note that the relative area ratio for evaluating the amount of peroxide is expressed by (peak area value derived from peroxide/peak area value derived from solvent) × 100 in a peak area ratio measured by high-performance liquid chromatography. The high-performance liquid chromatography used for the measurement may include an ultraviolet visible light detector and/or a chemiluminescence detector, and the relative area ratio can be measured by, for example, a method described in Examples.

Examples of a method for adjusting the amount of peroxide in the solvent used in step (I) to 0.1% or less include: method (i) using a relatively new solvent (solvent in which a relatively short time has passed after production); method (ii) for removing peroxide from a solvent; and a combination thereof.

As time passes after the solvent is produced, the solvent is gradually oxidized by oxygen or the like and the amount of peroxide increases. Therefore, method (i) is a method using the solvent before the amount of peroxide increases.

Examples of method (ii) include: a method for separating peroxide by distillation, column, or the like; and a method for adding a phosphorus-based antioxidant or a sulfur-based antioxidant to a solvent, and decomposing and removing peroxide with an oxidized phosphorus compound or an oxidized sulfur compound generated by a reaction with oxygen.

In addition, the solvent used in method (i) may be stored under conditions that suppress or prevent an increase in the amount of peroxide. Examples of a specific storage method include a method for storing the solvent in the presence of an antioxidant such as dibutylhydroxytoluene (BHT).

### (Dissolution method)

Examples of a method for heating and dissolvent a crude π-conjugated polymer in a solvent to obtain a polymer solution include a method for mixing, preferably stirring and mixing the crude π-conjugated polymer and the solvent under heating conditions. The heating temperature can be appropriately selected depending on the solubility of the crude π-conjugated polymer, but is preferably 40°C or higher, more preferably 50°C or higher, still more preferably 60°C or higher, preferably 200°C or lower, more preferably. Is 150°C or lower, and still more preferably 100°C or lower. When the heating temperature is the lower limit or higher, the crude π-conjugated polymer is easily dissolved and a polymer having high purity tends to be obtained, and therefore the electrical characteristics of an organic photoelectric conversion element are likely to be favorable. In addition, when the heating temperature is the upper limit or lower, decomposition of the π-conjugated polymer is easily suppressed, and therefore the electrical characteristics of an organic photoelectric conversion element are likely to be favorable. Note that heating and dissolving may be performed while reflux is performed with a cooling device or the like. The heating time can be appropriately selected depending on the solubility of the crude π-conjugated polymer and the heating temperature, but is preferably 10 minutes or more, more preferably 30 minutes or more, still more preferably 1 hour or more, preferably 24 hours or less, and more preferably 12 hours or less. Step (I) is preferably performed in an atmosphere of an inert gas (for example, nitrogen or argon) in order to prevent the solvent from being further oxidized to generate peroxide.

### <Step (II)>

Step (II) is a step of precipitating a π-conjugated polymer from the polymer solution obtained in step (I). A precipitating method is not particularly limited, and examples thereof include a method for adding a polymer solution to a poor solvent for the π-conjugated polymer. When the polymer solution is added, the temperature of the polymer solution and the temperature of the poor solvent are not particularly limited, and may be, for example, 10 to 50°C, and preferably 20 to 30°C. The polymer solution may be added all at once or may be added gradually to the poor solvent.

The poor solvent refers to a solvent in which the n-conjugated polymer has low solubility or the π-conjugated polymer is not dissolved. Therefore, the poor solvent can be appropriately selected depending on the type of n-conjugated polymer, and may be, for example, an aromatic solvent such as toluene or xylene; an ether-based solvent such as tetrahydrofuran or dimethoxyethane; an alcohol-based solvent such as methanol, ethanol, ethylene glycol, isopropyl alcohol, propylene glycol, ethylene glycol methyl ether, ethylene glycol butyl ether, 1-methoxy-2-propanol, 2-butoxyethanol, or propylene glycol monomethyl ether; an ester-based solvent such as ethyl acetate or butyl acetate; a ketone-based solvent such as acetone, methyl ethyl ketone, cyclopentanone, cyclohexanone, 2-heptanone, or methylisobutylketone; an aliphatic hydrocarbon solvent such as pentane, hexane, or heptane; an alicyclic hydrocarbon solvent such as ethylcyclohexane; a nitrile-based solvent such as acetonitrile; an amide-based solvent such as N,N-dimethylacetamide or N,N-dimethylformamide; a carbonate-based solvent such as ethylene carbonate or propylene carbonate; a sulfur-containing solvent such as dimethylsulfone, dimethylsulfoxide, or sulfolane; or a chlorine-containing solvent such as chloroform or chlorobenzene.

The precipitated π-conjugated polymer is separated from the solvent by concentration, filtration, or the like, and then, for example, dried if necessary to obtain the n-conjugated polymer.

### <π-Conjugated polymer>

The electron spin concentration of the π-conjugated polymer obtained by the production method of the present invention is 30 × 10¹⁶ Spin/g or less and/or 2.5 times or less the electron spin concentration of the crude n-conjugated polymer, and preferably, the electron spin concentration of the π-conjugated polymer obtained by the production method of the present invention is 30 × 10¹⁶ Spin/g and 2.5 times or less the electron spin concentration of the crude π-conjugated polymer Therefore, even if the π-conjugated polymer is produced through a purification step including heating, an increase in dark current and a decrease in EQE in an organic photoelectric conversion element using the π-conjugated polymer can be effectively suppressed.

The electron spin concentration is a parameter obtained based on an ESR spectrum measured by an election spin resonance (ESR) method. The ESR spectrum can be acquired using, for example, an X-band ESR device.

Specifically, first, an ESR spectrum that reflects the electron spin characteristics of a π-conjugated polymer to be measured is obtained by an ESR method using an ESR device. Since the area of the ESR spectrum correlates with the electron spin amount, the electron spin amount can be calculated from the area of the ESR spectrum.

The area of the ESR spectrum can be calculated using any conventionally known suitable calculation method or software available on the market.

As a method for calculating the electron spin amount from the obtained ESR spectrum area, any conventionally known suitable method can be used. Examples of the method for calculating the electron spin amount from the ESR spectrum area include a method described in Introduction to practical ESR (Kodansha Scientific Co., Ltd.).

The electron spin concentration (Spin/g) can be calculated by dividing the calculated electron spin amount by a weighed value of a π-conjugated polymer to be measured.

Note that the elec. spin concentrations of the n-conjugated polymer and the crude π-conjugated polymer can be measured by, for example, a method described in Examples.

The electron spin concentration of the π-conjugated polymer is preferably 2.3 times or less, more preferably 2.0 times or less, still more preferably 1.8 times or less, particularly preferably 1.5 times or less, and more particularly preferably 1.3 times or less the electron spin concentration of the crude π-conjugated polymer. When the electron spin concentration of the π-conjugated polymer is the above upper limit or less, it is easy to more effectively suppress an increase in dark current and a decrease in EQE in an organic photoelectric conversion element. In addition, the electron spin concentration of the π-conjugated polymer is usually 1.0 time or more the electron spin concentration of the crude π-conjugated polymer.

The electron spin concentration of the π-conjugated polymer is preferably 20 × 10¹⁶ Spin/g or less, more preferably 15 × 10¹⁶ Spin/g or less, still more preferably 10 × 10¹⁶ Spin/g or less, and particularly preferably 7.0 × 10¹⁶ Spin/g or less. When the electron spin concentration of the π-conjugated polymer is the above upper limit or less, dark current is easily decreased and the EQE is easily enhanced in an organic photoelectric conversion element. In addition, the electron spin concentration of the π-conjugated polymer is not particularly limited, but is usually 0.5 × 10¹⁶ Spin/g or more.

The structure of the π-conjugated polymer is the same as that of the crude π-conjugated polymer, and the weight average molecular weight (Mw) of the π-conjugated polymer can be selected from a similar range to the range of the weight average molecular weight of the crude π-conjugated polymer.

### [Method for producing organic photoelectric conversion element]

The present invention includes a method for producing an organic photoelectric conversion element including a pair of electrodes including an anode and a cathode, and an active layer disposed between the pair of electrodes and containing a π-conjugated polymer produced by the production method of the present invention.

In one embodiment of the present invention, the organic photoelectric conversion element has a layer structure in which substrate/anode/hole transport layer/active layer/electron transport layer/cathode are laminated in this order; or a layer structure in which substrate/cathode/electron transport layer/active layer/hole transport layer/anode are laminated in this order. Note that it is not essential that these layers are necessarily formed, and for example, a hole transport layer does not have to be included. In addition, it is not essential that these layers are formed separately, and for example, one layer may have both functions of an anode and a hole transport layer.

### <Active layer>

The active layer contains a p-type semiconductor material (electron-donating compound) and an n-type semiconductor material (electron-accepting compound). Whether the active layer is a p-type semiconductor material or an n-type semiconductor material can be relatively determined from an energy level of HOMO or LUMO of a selected organic semiconductor material.

In one embodiment of the present invention, the active layer preferably contains a π-conjugated polymer obtained by the production method of the present invention as a p-type semiconductor.

The thickness of the active layer is usually preferably 1 nm to 100 µm, more preferably 2 nm to 2000 nm, and still more preferably 5 nm to 1000 nm.

The active layer can be produced, for example, by a coating method using an ink composition for forming an active layer (also simply referred to as an ink composition or a coating liquid).

Here, an example of forming the active layer, which is a main component of an organic photoelectric conversion element, by a coating method will be described below. Such a step of forming the active layer may include the following steps (X) and (Y).

### (Step (X))

As a method for applying an ink composition to an application target, any suitable coating method can be used. As the coating method, a slit coating method, a knife coating method, a spin coating method, a micro gravure coating method, a gravure coating method, a bar coating method, an inkjet printing method, a nozzle coating method, or a capillary coating method is preferable, the slit coating method, the spin coating method, the capillary coating method, the knife coating method, or the bar coating method is more preferable, and the knife coating method, the slit coating method, or the spin coating method is still more preferable.

The ink composition is applied to an application target selected depending on an organic photoelectric conversion element and a method for producing the same. In the method for producing an organic photoelectric conversion element, the ink composition is applied to a functional layer which is included in the organic photoelectric conversion element and to which the active layer can be adjacent. Therefore, the application target of the ink composition differs depending on a layer structure and a layer formation order of an organic photoelectric conversion element to be produced. For example, when the organic photoelectric conversion element has a layer structure of substrate/anode/hole transport layer/active layer/electron transport layer/cathode, and a layer described on the left side is formed first, the application target of the ink composition is the hole transport layer. In addition, for example, when the organic photoelectric conversion element has a layer structure of substrate/cathode/electron transport layer/active layer/hole transport layer/anode, and a layer described on the left side is formed first, the application target of the ink composition is the electron transport layer.

### (Step (Y))

As a method for removing a solvent from a coating film of the ink composition, that is, a method for drying a coating film to remove a solvent and curing the coating film, any suitable method can be used. Examples of the method for removing a solvent include drying treatment using a direct heating method using a hot plate, a hot air drying method, an infrared heating drying method, a flash lamp annealing drying method, a vacuum drying method, or the like.

The step of forming the active layer may include other steps in addition to steps (X) and (Y) as long as the object and effects of the present invention are not impaired.

The organic photoelectric conversion element in one embodiment of the present invention may be an organic photoelectric conversion element including a plurality of active layers, and in such a case, the plurality of active layers may be produced by repeating steps (X) and (Y) a plurality of times.

### (Ink composition for forming active layer)

The ink composition that can be used in the step (X) may be a solution or a dispersion such as a dispersion, an emulsion, or a suspension. The ink composition in one embodiment of the present invention is an ink composition for forming an active layer, and contains a π-conjugated polymer which is a p-type semiconductor material, an n-type semiconductor material, and a first solvent, and can further contain a second solvent if desired.

The ink composition may contain only one type of p-type semiconductor material (π-conjugated polymer), or may contain two or more types thereof in combination at any ratio.

### (n-Type semiconductor material)

The n-type semiconductor material (electron-accepting compound) may be a low molecular weight compound or a high molecular weight compound.

Examples of an n-type semiconductor material that is a low molecular weight compound include an oxadiazole derivative, anthraquinodimethane and a derivative thereof, benzoquinone and a derivative thereof, naphthoquinone and a derivative thereof, anthraquinone and a derivative thereof, tetracyanoanthraquinodimethane and a derivative thereof, a fluorenone derivative, diphenyldicyanoethylene and a derivative thereof, a diphenoquinone derivative, 8-hydroxyquinoline and a metal complex of a derivative thereof, a fullerene such as a C₆₀ fullerene and a derivative thereof, and a phenanthrene derivative such as bathocuproine.

Examples of an n-type semiconductor material that is a high molecular weight compound include polyvinylcarbazole and a derivative thereof, polysilane and a derivative thereof, a polysiloxane derivative having an aromatic amine structure in a side chain thereof or a main chain thereof, polyaniline and a derivative thereof, polythiophene and a derivative thereof, polypyrrole and a derivative thereof, polyphenylene vinylene and a derivative thereof, polythienylene vinylene and a derivative thereof, polyquinolin and a derivative thereof, polyquinoxalin and a derivative thereof, and polyfluorene and a derivative thereof.

As the n-type semiconductor material, one or more types selected from a fullerene and a fullerene derivative are preferable, and a fullerene derivative is more preferable.

Examples of the fullerene include a C₆₀ fullerene, a C₇₀ fullerene, a C₇₆ fullerene, a C₇₈ fullerene, and a C₈₄ fullerene. Examples of the fullerene derivative include derivatives of these fullerenes. The fullerene derivative means a compound in which at least a part of a fullerene is modified.

Examples of the fullerene derivative include compounds represented by the following formulas (N-1) to (N-4).

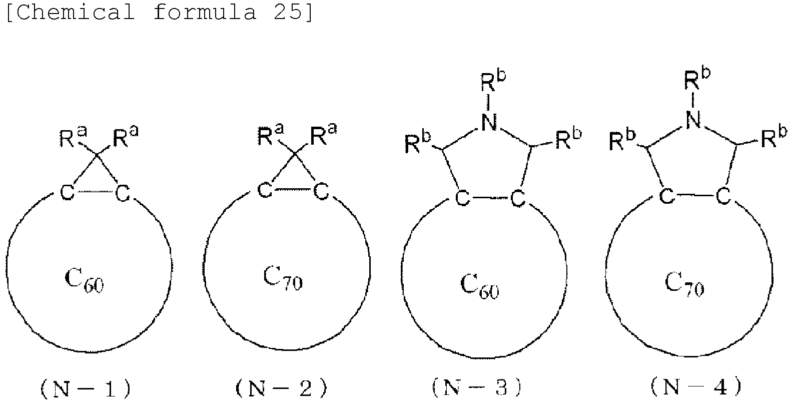

In formulas (N-1) to (N-4), R^{a} represents an alkyl group, an aryl group, a monovalent heterocyclic group, or a group having an ester structure. The plurality of R^{a}s may be the same as or different from each other.

In formulas (N-1) to (N-4), R^{b} represents an alkyl group or an aryl group. The plurality of R^{b}s may be the same as or different from each other.

Examples of the group having an ester structure represented by R^{a} include a group represented by the following formula (19).

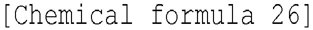

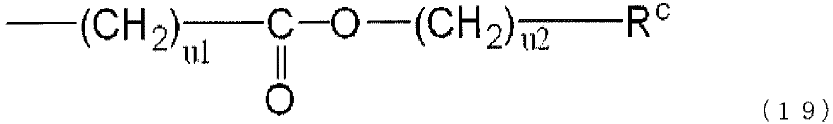

In formula (19), u1 represents an integer of 1 to 6. u2 represents an integer of 0 to 6. R^{c} represents an alkyl group, an aryl group, or a monovalent heterocyclic group.

Examples of the C₆₀ fullerene derivative include the following compounds.

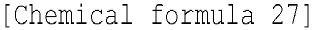

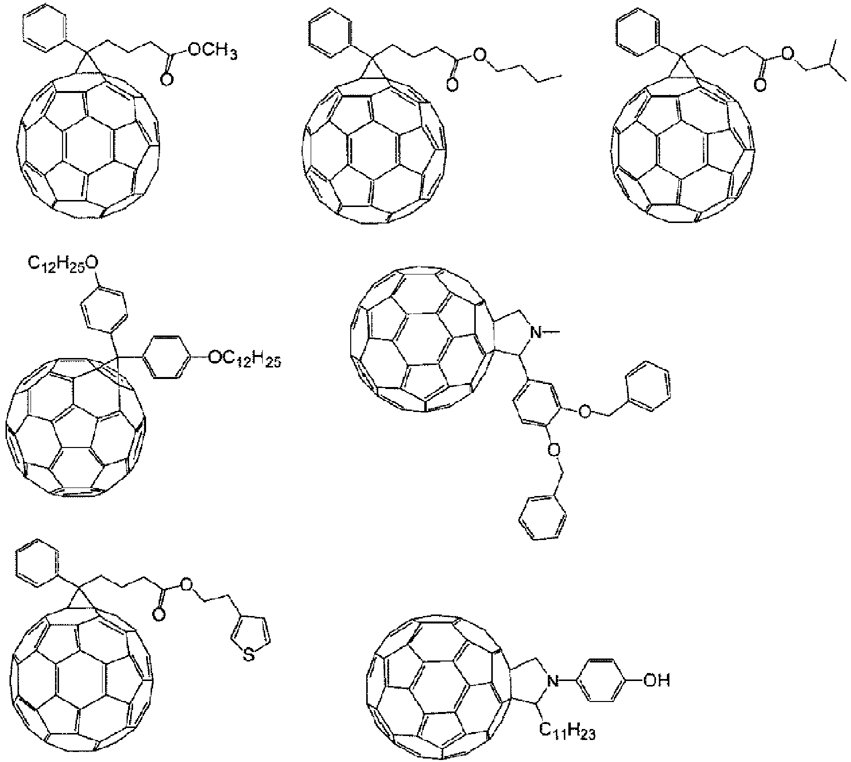

Examples of the C₇₀ fullerene derivative include the following compounds.

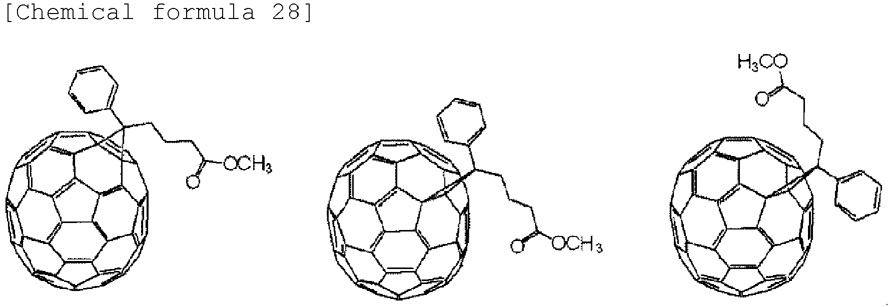

Specific examples of the fullerene derivative include [6,6]-phenyl-C61 butyric acid methyl ester (C60PCBM), [6,6]-phenyl-C71 butyric acid methyl ester (C70PCBM), [6,6]-phenyl-C85 butyric acid methyl ester (C84PCBM), and [6,6]-thienyl-C61 butyric acid methyl ester.

The ink composition may contain only one type of n-type semiconductor material, or may contain a combination of two or more types thereof at any ratio.

### (First solvent)

The solvent only needs to be selected in consideration of solubility for a selected p-type semiconductor material and n-type semiconductor material, and characteristics (boiling point and the like) corresponding to drying conditions for forming the active layer.

The first solvent which is a main solvent is an aromatic hydrocarbon optionally having a substituent (for example, an alkyl group or a halogen atom) (hereinafter, simply referred to as an aromatic hydrocarbon). The first solvent is preferably selected in consideration of the solubility of the selected p-type semiconductor material and n-type semiconductor material.

Examples of such an aromatic hydrocarbon include the aromatic solvents described in the (solvent) section.

The first solvent may contain only one type of aromatic hydrocarbon or may contain two or more types of aromatic hydrocarbons. The first solvent preferably contains only one type of aromatic hydrocarbon.

The first solvent preferably contains one or more types selected from the group consisting of toluene, o-xylene, m-xylene, p-xylene, mesitylene, pseudocumene, n-butylbenzene, sec-butylbenzene, tert-butylbenzene, methylnaphthalene, tetralin, indane, chlorobenzene, and o-dichlorobenzene, and more preferably contains o-xylene, pseudocumene, tetralin, chlorobenzene, or o-dichlorobenzene.

### (Second solvent)

The second solvent is preferably a solvent selected particularly from a viewpoint of enhancing the solubility of the n-type semiconductor material. Examples of the second solvent include a ketone-based solvent such as acetone, methyl ethyl ketone, cyclohexanone, acetophenone, or propiophenone, and an ester-based solvent such as ethyl acetate, butyl acetate, phenyl acetate, ethyl cellosolve acetate, methyl benzoate, butyl benzoate, or benzyl benzoate.

The second solvent is preferably acetophenone, propiophenone, or benzyl benzoate from a viewpoint of reducing dark current.

### (Combination of first solvent and second solvent)

Examples of a combination of the first solvent and the second solvent include combinations indicated in Table 1 below.

**[Table 1]**

| First solvent | Second solvent |
|---|---|
| Pseudocumene | Propiophenone |
| Pseudocumene | Benzyl benzoate |
| Tetralin | Propiophenone |
| o-Xylene | Acetophenone |

A mass ratio (first solvent/second solvent) of the first solvent (main solvent) to the second solvent (additional solvent) is preferably within a range of 85/15 to 95/5 from a viewpoint of further enhancing the solubility of the p-type semiconductor material and the n-type semiconductor material.

### (Total mass percentage of first solvent and second solvent in ink composition)

When the total mass of the ink composition is 100% by mass, the total mass of the first solvent and the second solvent contained in the ink composition is preferably 90% by mass or more, more preferably 92% by mass or more, and still more preferably 95% by mass or more from a viewpoint of further enhancing the solubility of the p-type semiconductor material and the n-type semiconductor material, and is preferably 99% by mass or less, more preferably 98% by mass or less, and still more preferably 97.5% by mass or less from a viewpoint of facilitating formation of a film having a certain thickness or more while increasing the content of the p-type semiconductor material and the n-type semiconductor material in the ink composition.

### (Optional solvent)

The ink composition may contain an optional solvent other than the first solvent and the second solvent. When the total mass of all the solvents contained in the ink composition is 100% by mass, the content of the optional solvent is preferably 5% by mass or less, more preferably 3% by mass or less, and still more preferably 1% by mass or less. As the optional solvent, a solvent having a boiling point higher than that of the second solvent is preferable.

### (Optional component)

In addition to the first solvent, the second solvent, the p-type semiconductor material (π-conjugated polymer), and the n-type semiconductor material, the ink composition may contain an optional component such as an ultraviolet absorber, an antioxidant, a sensitizer for sensitizing a function of generating charges by absorbed light, or a photostabilizer for increasing stability against ultraviolet rays as long as the object and effects of the present invention are not impaired.

### (Concentration of p-type semiconductor material and n-type semiconductor material in ink composition)

The total concentration of the p-type semiconductor material and the n-type semiconductor material in the ink composition is preferably 0.01% by mass to 20% by mass, more preferably 0.01% by mass to 10% by mass, still more particularly 0.01% by mass to 5% by mass, and particularly preferably 0.1% by mass to 5% by mass. The p-type semiconductor material and the n-type semiconductor material may be dissolved or dispersed in the ink composition. The p-type semiconductor material and the n-type semiconductor material are preferably at least partially dissolved, and are more preferably all dissolved.

### (Preparation of ink composition)

The ink composition can be prepared by a known method. For example, the ink composition can be prepared by a method for mixing the first solvent and the second solvent to prepare a mixed solvent and adding the p-type semiconductor material and the n-type semiconductor material to the mixed solvent, or a method for adding the p-type semiconductor material to the first solvent, adding the n-type semiconductor material to the second solvent, and then mixing the first solvent containing the p-type semiconductor material and the second solvent containing the n-type semiconductor material.

The first solvent and the second solvent, and the p-type semiconductor material and the n-type semiconductor material may be heated and mixed at a temperature equal to or lower than the boiling point of the solvent.

After the first solvent and the second solvent are mixed with the p-type semiconductor material and the n-type semiconductor material, the obtained mixture may be filtered using a filter, and the obtained filtrate may be used as the ink composition.

As the filter, for example, a filter made of a fluororesin such as polytetrafluoroethylene (PTFE) can be used.

### <Substrate>

The organic photoelectric conversion element is usually formed on a substrate. Electrodes including a cathode and an anode are usually formed on this substrate. A material of the substrate is not particularly limited as long as the material is not chemically changed when a layer containing an organic compound is formed. Examples of a material of the substrate include glass, plastic, a polymer film, and silicon. As the substrate, a substrate on which an electrode described later is formed or a substrate having a layer of a conductive material capable of functioning as an electrode by being patterned can be prepared and used. Examples of the substrate having a layer of a conductive material include a glass substrate on which a layer of indium tin oxide (ITO) is formed.

### <Electrode>

Examples of a material of a transparent or translucent electrode include a conductive metal oxide film and a translucent metal thin film. Specific examples thereof include indium oxide, zinc oxide, tin oxide, a conductive material which is a composite thereof, such as ITO, indium zinc oxide (IZO), or NESA, gold, platinum, silver, and copper. As the material of the transparent or translucent electrode, ITO, IZO, and tin oxide are preferable. In addition, as the electrode, a transparent conductive film using an organic compound such as polyaniline and a derivative thereof or polythiophene and a derivative thereof as a material may be used. The transparent or translucent electrode may be an anode or a cathode. When the substrate is opaque, an electrode on a side opposite to an electrode disposed on the opaque substrate side (that is, an electrode on a side far from the substrate) is preferably a transparent or translucent electrode.

If one of the pair of electrodes is transparent or translucent, the other electrode may be an electrode having low light transmission. Examples of a material of the electrode having low light transmission include a metal and a conductive polymer. Specific examples of the material of the electrode having low light transmission include a metal such as lithium, sodium, potassium, rubidium, cesium, magnesium, calcium, strontium, barium, aluminum, scandium, vanadium, zinc, yttrium, indium, cerium, samarium, europium, terbium, or ytterbium, an alloy made of two or more types selected from these metals, an alloy made of one or more types selected from these metals and one or more types of metals selected from the group consisting of gold, silver, platinum, copper, manganese, titanium, cobalt, nickel, tungsten, and tin, graphite, a graphite interlayer compound, polyaniline and a derivative thereof, and polythiophene and a derivative thereof. Examples of the alloy include a magnesium-silver alloy, a magnesium-indium alloy, a magnesium-aluminum alloy, an indium-silver alloy, a lithium-aluminum alloy, a lithium-magnesium alloy, a lithium-indium alloy, and a calcium-aluminum alloy.

As a method for forming the electrode, any conventionally known suitable forming method can be used. Examples of the method for forming the electrode include a vacuum vapor deposition method, a sputtering method, an ion plating method, and a plating method.

### <Intermediate layer>

The organic photoelectric conversion element may include an additional intermediate layer such as a charge transport layer (for example, an electron transport layer, a hole transport layer, an electron injection layer, or a hole injection layer) as an additional component for enhancing characteristics such as organic photoelectric conversion efficiency.

As a material used for such an intermediate layer, any conventionally known suitable material can be used. Examples of the material of the intermediate layer include a halide and an oxide of an alkali metal or an alkaline earth metal, such as lithium fluoride.

In addition, examples of the material used for the intermediate layer include fine particles of an inorganic semiconductor such as titanium oxide, and a mixture (PEDOT : PSS) of poly (3,4-ethylenedioxythiophene (PEDOT) and poly (4-styrene sulfonate) (PSS).

The organic photoelectric conversion element may include a hole transport layer between the anode and the active layer. The hole transport layer has a function of transporting holes from the active layer to the electrode.

The hole transport layer disposed in contact with the anode may be particularly referred to as a hole injection layer. The hole transport layer (hole injection layer) disposed in contact with the anode has a function of promoting injection of holes into the anode. The hole transport layer (hole injection layer) may be in contact with the active layer.

The hole transport layer contains a hole-transporting material. Examples of the hole-transporting material include polythiophene and a derivative thereof, an aromatic amine compound, a high molecular weight compound containing a constituent unit having an aromatic amine residue, CuSCN, CuI, NiO, and molybdenum oxide (MoO₃).

The organic photoelectric conversion element may include an electron transport layer between the cathode and the active layer. The electron transport layer has a function of transporting electrons from the active layer to the cathode. The electron transport layer may be in contact with the cathode. The electron transport layer may be in contact with the active layer.

The electron transport layer contains an electron-transporting material. Examples of the electron-transporting material include zinc oxide nanoparticles, gallium-doped zinc oxide nanoparticles, aluminum-doped zinc oxide nanoparticles, polyethyleneimine, ethoxylated polyethyleneimine (polyethyleneimine ethoxylate), and PFN-P2.

The intermediate layer can be formed by a coating method similar to the method for producing an active layer described above.

### <Sealing layer>

The organic photoelectric conversion element may further include a sealing layer. The sealing layer can be disposed, for example, on an electrode side farther from the substrate, or on a peripheral portion of the organic photoelectric conversion element. The sealing layer can be formed by a method suitable for a selected material by using a material having a property of blocking water (water vapor barrier property) or a property of blocking oxygen (oxygen barrier property).

The organic photoelectric conversion element in the present invention can be produced by forming the active layer between the electrodes by the method described above. In addition, a layer structure in which substrate/anode/hole transport layer/active layer/electron transport layer/cathode are laminated in this order or a layer structure in which substrate/cathode/electron transport layer/active layer/hole transport layer/anode are laminated in this order in one embodiment of the present invention can be produced, for example, by forming the layers in order from the substrate side using the method described above.

### <Organic photoelectric conversion element>

Since the organic photoelectric conversion element produced by the method of the present invention includes the active layer containing the π-conjugated polymer in the present invention, even if the π-conjugated polymer is produced through a purification step including heating and dissolving, an increase in dark current and a decrease in EQE are effectively suppressed. Therefore, dark current can be low, and EQE can be high. Therefore, the organic photoelectric conversion element produced by the method of the present invention can be used for an organic photodiode, a solar cell, and the like. In particular, the organic photoelectric conversion element in the present invention is useful as an organic photoelectric conversion element for an organic photodiode.

### EXAMPLES

Hereinafter, the present invention will be specifically described with reference to Examples, but Examples do not limit the scope of the present invention.

A measurement method and an evaluation method will be described below.

### [Peroxide in solvent]

In Examples and Comparative Examples, the content of peroxide in a solvent was determined by liquid chromatography including an ultraviolet detector.

### <Analysis conditions>

Measuring device: Shimadzu LC-20A
Column: L-Column2 ODS (manufactured by Chemicals Evaluation and Research Institute)
Column temperature: 40°C
Mobile phase: water and acetonitrile
Flow rate: 1.0 mL/min
Detection wavelength: 230 nm, chemiluminescence detector

Specifically, using a liquid chromatograph device including an ultraviolet visible light detector, an ultraviolet visible light chromatogram of a solvent was measured, and an area value A of a peak derived from the solvent in the ultraviolet visible light chromatogram was calculated. Next, using a liquid chromatograph device including a chemiluminescence detector and an ultraviolet visible light detector, a chemiluminescent chromatogram and an ultraviolet visible light chromatogram of an evaluation aqueous solution prepared by mixing the solvent, a chemiluminescent reagent (luminol solution), a chemiluminescent catalyst (chitochrome C), sodium hydroxide, and boric acid were measured, and an area value B of a peak in the ultraviolet visible light chromatogram of the solvent having a retention time corresponding to a peak in the chemiluminescent chromatogram of the solvent was calculated. A value obtained by multiplying a ratio (B/A) of the peak area value B to the peak area value A by 100 was determined as a relative amount value (R). The relative amount area ratio (R) indicates the content of the amount of peroxide in the solvent according to an area value measured by high-performance liquid chromatography.

### [Spin concentration analysis of π-conjugated polymer]

### <Creation of calibration curve>

Spin concentration analysis was performed using an X-band ESR device manufactured by JEOL Ltd. A calibration curve indicating correlation between a spin amount and an ESR signal area value was created using 2,2,6,6-tetramethylpiperidine-1-oxyl (TEMPO) as a standard substance. For the spin concentration analysis, 1.02 mg of TEMPO was weighed and dissolved in 10 mL of toluene to prepare a 0.65 mM TEMPO solution (standard 1). 1 mL of the obtained solution was weighed and put in a 10 mL volumetric flask to prepare a 0.065 mM solution (standard 2). Solutions of 0.0065 mM (standard 3) and 0.00065 mM (standard 4) were prepared by a similar operation. ESR measurement was performed for the obtained standard solutions 1 to 4, and area values of the obtained spectra were determined. A calibration curve was created from the obtained numerical values.

### <Measurement of spin concentration>

3 mg of each of the π-conjugated polymers obtained in Examples and Comparative Examples was weighed and put in an ESR tube (5 mϕ), and ESR measurement was performed. From an area value of the obtained spectrum, a total spin amount was quantified using the calibration curve. The obtained spin amount was divided by the weighed value of the π-conjugated polymer to obtain a spin concentration (Spin·g⁻¹·10¹⁶).

### <Evaluation of characteristics of organic photoelectric conversion element>

Dark current (Jd) of each of the organic photoelectric conversion elements obtained in Examples and Comparative Examples was measured using a spectral sensitivity measuring device (CEP-2000, manufactured by Spectrometer Co., Ltd.) and a semiconductor parameter analyzer (Agilent Technology B1500A, manufactured by Agilent Technology).

### [Weight average molecular weight (Mw) of π-conjugated polymer]

The weight average molecular weight of the π-conjugated polymer in terms of polystyrene was determined by gel permeation chromatography (GPC).
Column: TOSOH TSKgel Super HM-H (2 pieces) + TSKgel Super H2000 (4.6 mm I.d. × 15 cm)
Detector: RI (SHIMADZU RID-10A)
Mobile phase: tetrahydrofuran (THF)

In the present Examples, the crude π-conjugated polymers (p-type semiconductor materials) and n-type semiconductor material described in the Table below were used.

**[Table 2]**

| | No. | Chemical structure |
|---|---|---|
| π-Conjugated polymer (p-Type semiconductor material) | P-1 | 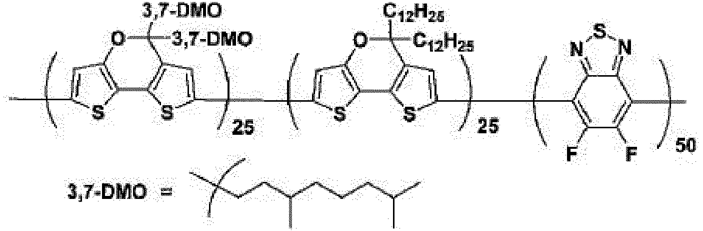 |
| | P-2 | 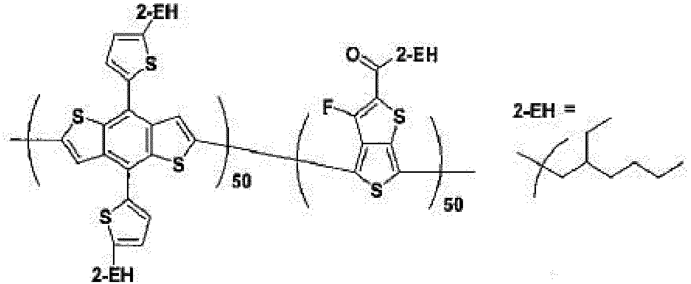 |
| | P-3 | 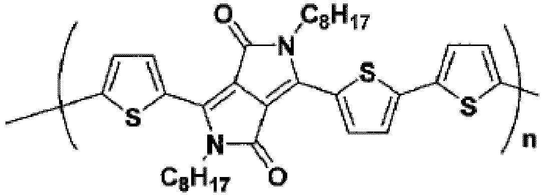 |
| n-Type semiconductor material | N-1 | 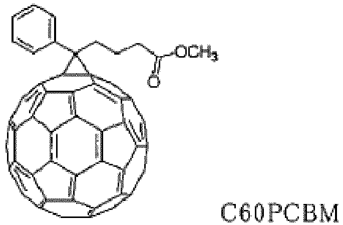 |

P-1 was synthesized with reference to a method described in WO-A-2013/051676. The weight average molecular weight (Mw) of the crude π-conjugated polymer (P-1) was 62,200.

For P-2, a trade name: "PCE10" manufactured by 1-Material was used. The weight average molecular weight (Mw) of the crude π-conjugated polymer (P-2) was 144,000.

As P-3, a trade name: "PDPP3T" manufactured by Lumtec was used. The weight average molecular weight (Mw) of the crude π-conjugated polymer (P-3) was 59,400.

For N-1, a trade name: "E100" manufactured by Frontier Carbon Co., Ltd. was used.

### [Example 1]

### <Production of π-conjugated polymer>

The inside of a glass reaction vessel including a cooling device was formed into a nitrogen gas atmosphere. Thereafter, to the reaction vessel, 0.1 g of the crude π-conjugated polymer (P-1) synthesized with reference to the method described in WO-A-2013/051676 and 9.9 g of tetrahydronaphthalene (tetralin) having a peroxide content of 0.03% were added, and then heated and dissolved at 80° C for seven hours. The obtained polymer solution was poured into methanol to precipitate a π-conjugated polymer. The obtained π-conjugated polymer is referred to as E-1.

### <Preparation of ink composition for forming active layer>

The π-conjugated polymer (E-1) and C₆₀PCBM (manufactured by Frontier Carbon Co., Ltd., trade name: E100) were mixed at a mass ratio of 1 : 2. The mixture was added to a mixed solvent of o-xylene as the first solvent and acetophenone as the second solvent (o-xylene : acetophenone = 95 : 5 (mass ratio)), and stirred at 80°C for 10 hours to prepare an ink composition. Note that the content of the π-conjugated polymer (E-1) was 0.66% by mass, and the content of C₆₀PCBM was 1.32% by mass based on the mass of the ink composition.

### <Production of organic photoelectric conversion element>

A glass substrate on which ITO had been formed so as to have a thickness of 150 nm by a sputtering method was subjected to ozone UV treatment to perform surface treatment. Next, a coating solution obtained by diluting polyethyleneimine ethoxylate (PEIE) (manufactured by Aldrich, trade name: polyethyleneimine, 80% ethoxylated solution, weight average molecular weight: 110,000) 1/500 times with 2-methoxyethanol was applied onto the ITO thin film of the glass ITO substrate by a spin coating method.

The glass substrate to which the coating solution had been applied was heated at 120°C for 10 minutes using a hot plate to form an electron transport layer 1 on the ITO thin film as a first electrode.

The ink composition obtained above was applied onto the electron transport layer 1 of the glass substrate by a knife coating method to obtain a coating film. The obtained coating film was dried for five minutes using a hot plate heated to 100°C to form an active layer. The thickness of the formed active layer was 500 nm. Next, PEDOT (manufactured by Heraeus, trade name: FHC Solar) was applied as an anode onto the active layer by a spin coating method, and dried for 30 minutes using an oven heated to 85°C. The formed PEDOT layer had a thickness of 100 nm. A UV curable sealant was applied to a peripheral portion of the obtained organic photoelectric conversion element, and a glass substrate as a sealing substrate was bonded thereto. Thereafter, the photoelectric conversion element was irradiated with UV light to be sealed. The planar shape of the obtained photoelectric conversion element was a square of 2 mm × 2 mm when viewed in a thickness direction.

### [Example 2]

A π-conjugated polymer (E-2) and an organic photoelectric conversion element were obtained in a similar manner to Example 1 except that the π-conjugated polymer (P-2) was used instead of the π-conjugated polymer (P-1).

### [Example 3]

A π-conjugated polymer (E-3) and an organic photoelectric conversion element were obtained in a similar manner to Example 1 except that the π-conjugated polymer (P-3) was used instead of the π-conjugated polymer (P-1).

### [Comparative Example 1]

A π-conjugated polymer (C-1) and an organic photoelectric conversion element were obtained in a similar manner to Example 1 except that the content of peroxide in tetrahydronaphthalene was changed from 0.03% to 0.17%.

### [Comparative Example 2]

A π-conjugated polymer (C-2) and an organic photoelectric conversion element were obtained in a similar manner to Comparative Example 1 except that the π-conjugated polymer (P-2) was used instead of the π-conjugated polymer (P-1).

### [Comparative Example 3]

A π-conjugated polymer (C-3) and an organic photoelectric conversion element were obtained in a similar manner to Comparative Example 1 except that the π-conjugated polymer (P-3) was used instead of the π-conjugated polymer (P-1).

Table 3 below indicates an electron spin concentration (Spin/g) of a crude π-conjugated polymer, an electron spin concentration (Spin/g) of a π-conjugated polymer, a ratio (times) of an electron spin concentration of a π-conjugated polymer to a crude π-conjugated polymer, and dark current (nA) of an organic photoelectric conversion element in each of Examples 1 to 3 and Comparative Examples 1 to 3.

**[Table 3]**

| | Content of peroxide in solvent (%) | Type of π-conjugated polymer | Electron spin concentration of crude π-conjugated polymer (Spin·g⁻¹·10¹⁶) | Electron spin concentration of π-conjugated polymer (Spin·g⁻¹·10¹⁶) | Ratio of electron spin concentration (times) | Dark current of organic photoelectric conversion element (nA) |
|---|---|---|---|---|---|---|
| Example 1 | 0.03 | P-1 | 5.5 | 7.9 | 1.44 | 1.4 |
| Example 2 | 0.03 | P-2 | 0.4 | 0.4 | 1 | 1.6 |
| Example 3 | 0.03 | P-3 | 5.8 | 6.0 | 1.03 | 0.5 |
| Comparative Example 1 | 0.17 | P-1 | 5.5 | 64.4 | 11.7 | 3.4 |
| Comparative Example 2 | 0.17 | P-2 | 0.4 | 1.8 | 4.5 | 6.2 |
| Comparative Example 3 | 0.17 | P-3 | 5.8 | 15.5 | 2.67 | 1.1 |

In Example 1 and Comparative Example 1, an organic photoelectric conversion element is formed using a π-conjugated polymer produced from the same type of crude π-conjugated polymer. As indicated in Table 3, it has been confirmed that dark current of Example 1 is remarkably smaller than that of Comparative Example 1. In addition, the same result was obtained for Example 2 and Comparative Example 2, and for Example 3 and Comparative Example 3.

Therefore, it has been confirmed that the π-conjugated polymer produced by the method of the present invention can suppress an increase in dark current of an obtained organic photoelectric conversion element even if the method includes a purification step including heating.

## Claims

1. A method for producing a π-conjugated polymer, the method comprising: step (I) of heating and dissolving a crude π-conjugated polymer in a solvent to obtain a polymer solution; and step (II) of precipitating a π-conjugated polymer from the polymer solution, wherein
in step (I), a content of peroxide in the solvent is 0.1% or less in terms of a relative area ratio measured by high-performance liquid chromatography, and
an electron spin concentration of the π-conjugated polymer is 30 × 10¹⁶ Spin/g or less and/or 2.5 times or less an electron spin concentration of the crude π-conjugated polymer.

2. The method according to claim 1, wherein the crude π-conjugated polymer is a D-A type crude π-conjugated polymer, and the π-conjugated polymer is a D-A type π-conjugated polymer.

3. The method according to claim 1 or 2, wherein in step (I), the solvent contains at least one selected from the group consisting of a benzyl hydrogen-containing aromatic solvent, a halogen atom-containing aromatic solvent, and an ether-based solvent.

4. The method according to any one of claims 1 to 3, wherein in step (I), the crude π-conjugated polymer is heated and dissolved at a temperature of 40°C or higher.

5. A method for producing an organic photoelectric conversion element including a pair of electrodes including an anode and a cathode, and an active layer disposed between the pair of electrodes and containing a π-conjugated polymer produced by the method according to any one of claims 1 to 4.
